# EUROPÄISCHE PATENTSCHRIFT

(11) **EP 0 354 265 B1**
(45) Veröffentlichungstag und Bekanntmachung des Hinweises auf die Patenterteilung: **29.12.1993**
(21) Anmeldenummer: 88113074.4
(22) Anmeldetag: 11.08.1988
(51) Int. Cl.: G11C 7/00

(54) **Integrierte Halbleiterschaltung mit einem Speicherbereich**
Integrated semiconductor circuit having a memory space
Circuit intégré à semi-conducteurs ayant un champ de mémoire

(43) Veröffentlichungstag der Anmeldung: 14.02.1990
(73) Patentinhaber: SIEMENS AKTIENGESELLSCHAFT, 80333 München (DE)
(72) Erfinder: Hoffmann, Kurt, Dr. Prof., D-8021 Taufkirchen (DE); Kraus, Rainer, Dr., D-8000 München 83 (DE); Kowarik, Oskar, Dr., D-8018 Grafing (DE)

(56) Entgegenhaltungen:
- EP-A- 0 278 391
- US-A- 3 699 538
- US-A- 4 025 907

## Beschreibung

### Beschreibung für Vertragsstaaten : AT, IT, NL

Die vorliegende Erfindung betrifft eine integrierte Halbleiterschaltung nach dem Oberbegriff des Patentanspruches 1.

Bildverarbeitung, Musterverarbeitung und Verknüpfungen von Massendaten in Datenbanksystemen treten bei der modernen Datenverarbeitung zunehmend in den Vordergrund. Diesen Tätigkeiten ist gemeinsam, daß sehr große Datenmengen zu verarbeiten sind. Traditionelle Datenverarbeitungssysteme führen die Verarbeitung seriell durch. Dies erfordert einen hohen Zeitaufwand, weil beispielsweise beim Suchen nach einem bestimmten Begriff sehr viele Daten aus einem Speicherbereich serial ausgelesen werden müssen und im Prozessor mit dem Suchbegriff verglichen werden müssen, bis der gewünschte Begriff gefunden ist.

Eine Teillösung dieses Problems stellt der Einsatz inhaltsadressierbarer integrierter Halbleiterspeicher (CAM) dar. Dies hat jedoch zwei Nachteile: Zum einen weisen die derzeit erhältlichen CAM-Speicher eine gegenüber modernen verfügbaren RAM- bzw. ROM-Speicherbausteinen (1MBit Speicherkapazit) sehr geringe Speicherkapazität auf (maximal 8kBit; vgl. IEEE Journal of Solid-State Circuits, Vol. SC-20, No. 5, Oktober 1985, Seiten 951 bis 956) und zum anderen können diese Speicherbausteine lediglich assoziative Funktionen ausführen, nicht jedoch andere digitale Funktionen (z.B. logische, arithmetische). CAM-Speicherbausteine sind außerdem nicht wie übliche RAM- bzw. ROM-Speicherbausteine betreibbar.

Eine weitere Teillösung stellt die Kombination spezieller Prozessoren mit Speicherbausteinen in Parallel-Computern dar ("Transputer"). Transputer jedoch sind teuer, aufwendig zu konfigurieren und nicht universell, d.h. für beliebige Einsatzzwecke verwendbar.

Aufgabe der vorliegenden Erfindung ist es, einen üblichen Halbleiterspeicherbausteinmit möglichst wenig Aufwand so weiterzubilden, daß sein Einsatz den üblicherweise benötigten Zeitaufwand verringert und daß er möglichst universal einsetzbar ist.

Diese Aufgabe wird bei einer gattungsgemäßen Halbleiterschaltung gelöst durch die kennzeichnenden Merkmale des Patentanspruches 1. Vorteilhafte Aus- und Weiterbildungen sind in Unteransprüchen gekennzeichnet.

Die Erfindung wird im folgenden anhand der Zeichnung näher erläutert: Es zeigen
FIG 1 einen unmaßstäblichen, globalen Überblick über die erfindungsgemäße Schaltung,
FIG 2 einen Ausschnitt daraus,
die FIG 3 bis 9 vorteilhafte Ausgestaltungen von einzelnen logischen Einheiten der Schaltung.

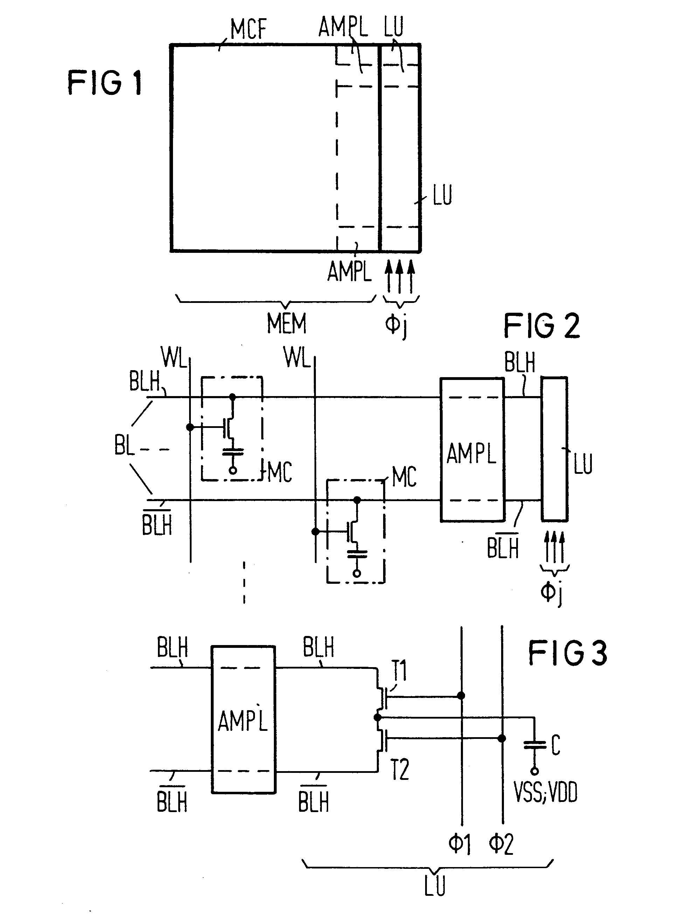

Gemäß FIG 1 enthält die erfindungsgemäße integrierte Halbleiterschaltung außer einem als solchen bekannten Speicherbereich MEM einen Block logischer Einheiten LU. Der Speicherbereich MEM enthält ein oder mehrere Speicherzellenfelder MCF mit über Wortleitungen WL und Bitleitungen BL adressierbaren Speicherzellen MC. Er enthält weiterhin eine der Anzahl der Bitleitungen BL entsprechende Anzahl von Bewerterschaltungen AMPL. Jede Bewerterschaltung AMPL ist, wie in FIG 2 ausschnittsweise dargestellt, so mit einer Bitleitung BL verbunden, daß sie diese in zwei wenigstens annähernd gleiche Bitleitungshälften BLH, BLH aufteilt. Ob diese Aufteilung nach dem Open-Bitline-Konzept oder nach dem Folded-Bitline-Konzept erfolgt ist, ist unwichtig für die vorliegende Erfindung.

Die erfindungsgemäße integrierte Halbleiterschaltung enthält weiterhin einen Block von logischen Einheiten LU. Jede logische Einheit LU ist mit einer Bitleitung BL über deren beide Bitleitungshälften BLH,BLH verbunden. Die Verbindung kann innerhalb oder außerhalb der jeweiligen logischen Einheit LU erfolgen, beispielsweise durch Weiterführung der Bitleitung BL bis zur betreffenden logischen Einheit LU, wie dargestellt.

Die logischen Einheiten LU dienen einer digitalen Verarbeitung von aus dem Speicherbereich MEM über die Bitleitungen BL ausgelesenen, in den Bewerterschaltungen AMPL bewerteten und verstärkten Daten A sowie von zu den Daten A komplementären Daten Ä, die bekanntlich beim Bewerte- und Verstärkungsvorgang entstehen. Unter "digitale Verarbeitung" wird dabei insbesondere verstanden: Logische Verknüpfung zweier Bits (OR,AND,etc.), Invertieren eines oder mehrerer Bits, logische Vergleiche von Worten miteinander, arithmetische Operationen. Der Block logischer Einheiten LU ist dazu in verschiedenen Betriebsarten MODk (k = 1...n) betreibbar. Der Auswahl der Betriebsarten MODk dienen Betriebsarten-Auswahlsignale 0j (j = 1...m).

Aufbau und Funktion der Erfindung sind nachstehend meist anhand einer einzelnen logischen Einheit LU beschrieben. Unabhängig davon werden jedoch alle logischen Einheiten LU des Blockes parallel zueinander betrieben.

In einer ersten Betriebsart MOD1 sind sämtliche Betriebsarten-Auswahlsignale 0j deaktiviert, wodurch alle logischen Einheiten LU ebenfalls deaktiviert sind. In Betrieb bleiben die ausgelesenen, bewerteten Daten A somit bei dieser Ausgestaltung der Erfindung unverändert. Das Betriebsverhalten der integrierten Halbleiterschaltung ist also in der ersten Betriebsart MOD1 identisch mit dem eines vergleichbaren Halbleiterspeicherbausteins, der den Block logischer Einheiten LU nicht enthält. Die erfindungsgemäße Halbleiterschaltung ist demzufolge elektrisch kompatibel mit einem entsprechenden Halbleiterspeicherbaustein.

In der Ausführungsform nach FIG 3 enthält jede logisch Einheit LU wenigstens zwei Transistoren T1,T2 und einen Ladekondensator C. Die Transistoren T1,T2 dienen einer Inversion der an den Bitleitungen BL anliegenden bewerteten Daten A. Die Drains der Transistoren T1,T2 sind gemeinsam mit einem ersten Anschluß des Ladekondensators C verbunden. Der zweite Anschluß des Ladekondensators C ist mit einem festen Potential verbunden. Es empfiehlt sich, als festes Potential eines der der Spannungsversorgung der integrierten Halbleiterschaltung dienenden Potentiale VSS (entsprechend Masse) oder VDD zu verwenden. Die Source des ersten Transistors T1 ist mit der einen Bitleitungshälfte BLH verbunden; die Source des zweiten Transistors T2 ist mit der anderen Bitleitungshälfte BLH verbunden. Zwei erste Betriebsarten-Auswahlsignale 01,02 sind mit den Gates des ersten bzw. zweiten Transistors T1,T2 verbunden.

Die somit mögliche Inversion der Daten A stellt die zweite Betriebsart MOD2 dar. Die Inversion der Daten A erfolgt in Betrieb folgendermaßen: Zunächst wird, wie bei jedem Halbleiterspeicher nach dem Stande der Technik üblich, ein Datum A aus einer Speicherzelle MC ausgelesen, über die der Speicherzelle MC zugeordnete Bitleitungshälfte (im Beispiel sei die eine Bitleitungshälfte BLH angenommen) auf die Bewerterschaltung AMPL gegeben und dort bewertet und verstärkt. Das Datum A liegt auch an der Source des ersten Transistors T1 an. Nun wird das mit dem ersten Transistor T1 verbundene eine (01) der beiden ersten Betriebsarten-Auswahlsignale 01,02 aktiviert. Das Datum A gelangt auf den Ladekondensator C und lädt bzw. entlädt diesen, je nach Wert des Datums A (log. "1 ", log. "0"). Anschließend werden das eine erste Betriebsarten-Auswahlsignal 01 deaktiviert und das andere erste Betriebsarten-Auswahlsignal 02 aktiviert. Infolgedessen sperrt der eine Transistor T1; der andere Transistor T2 leitet. Die auf dem Ladekondensator C gespeicherte Ladung gelangt dadurch über die andere Bitleitungshälfte (im Beispiel: BLH) an die Bewerterschaltung AMPL. Die Bewerterschaltung AMPL wird nun nochmals aktiviert, so daß sie das anliegende Datum bewertet. Da das Datum A bei dieser erneuten Bewertung jedoch an der anderen Bitleitungshälfte BLH anliegt (verglichen mit der ursprünglichen Bewertung), kippt die Bewerterschaltung AMPL in ihren komplementären Zustand, wodurch an der ursprünglichen einen Bitleitungshälfte BLH jetzt ein zum ursprünglich ausgelesenen bewerteten Datum A invertiertes Datum A anliegt. Dieses kann nun über die üblichen Speichereinrichtungen aus der Halbleiterschaltung ausgelesen werden und/oder in eine beliebige Speicherzelle MC an derselben Bitleitungshälfte BLH eingeschrieben werden. In Speicherzellen MC, die an der anderen Bitleitungshälfte BLH liegen, kann das ursprüngliche Datum A eingeschrieben werden.

Liegt das ausgelesene, bewertete Datum A vor der Dateninversion jedoch an der anderen Bitleitungshälfte BLH an (dies wird bekanntlich üblicherweise durch ein bestimmtes, frei wählbares Bit der Wortleitungsadresse entschieden), so kann entsprechend die Funktion der beiden ersten Betriebsarten-Auswahlsignale 01,02miteinander vertauscht werden (gesteuert ggf. ebenfalls durch das obengenannte Bit der Wortleitungsadresse). Das Vertauschen ist jedoch nicht notwendig, da an den beiden Bitleitungshälften BLH,BLH (bei intakten Speichern) nach erfolgter Bewertung stets zueinander komplementäre Daten anliegen: In diesem Fall wird bei Durchführung der zweiten Betriebsart MOD2, genau genommen, an der einen Bitleitungshälfte BLH nicht das ursprünglich (auf die andere Bitleitungshälfte BLH) ausgelesene, bewertete Datum A invertiert, sondern das dazu komplementäre Datum Ä. Dies ist jedoch ohne Belang, weil anschließend an das Aktivieren der Betriebsarten- Auswahlsignale 01,02 durch das erneute Bewerten in der Bewerterschaltung AMPL an der zweiten Bitleitungshälfte BLH ein zum ursprünglich ausgelesenen Datum A komplementäres Datum Ä entsteht.

Bekanntlich werden bei einem integrierten Halbleiterspeicher durch das Adressieren einer einzigen Speicherzelle MC über eine adressierte Wortleitung WL und eine Bitleitungsadresse die in allen Speicherzellen MC an der adressierten Wortleitung WL gespeicherten Daten Ai über die Bitleitungen BLi parallel ausgelesen und mittels aller Bewerterschaltungen AMPL bewertet und verstärkt. Die Auswahl eines bestimmten Datums A aus der Menge der Daten Ai mittels einer Bitleitungsadresse erfolgt anschließend; dabei wird dasjenige Datum A, das an der adressierten Bitleitung BL liegt und das bewertet und verstärkt wurde, auf eine externe Bitleitung ausgegeben. Aufgrund dieser Gegebenheiten läuft demzufolge auch die beschriebene zweite Betriebsart MOD2 parallel für den gesamten Block logischer Einheiten LU ab. Die zweite Betriebsart MOD2 ermöglicht also ein gleichzeitiges Invertieren von Daten Ai aller Speicherzellen MC einer Wortleitung WL.

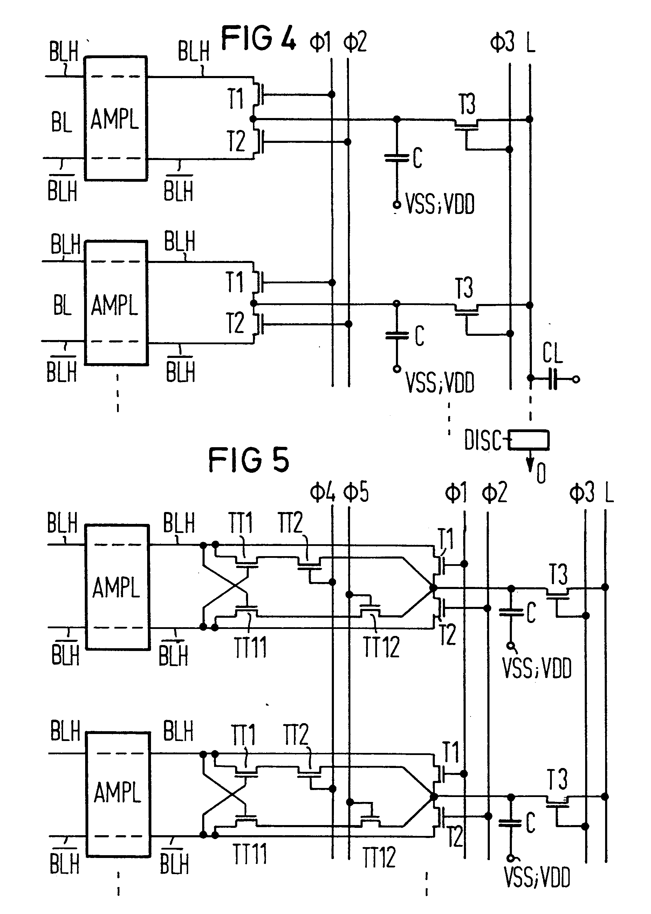

In der Ausführungsform nach FIG 4 enthält der Block von logischen Einheiten LU weiterhin eine gemeinsame Leitung L, die, wie allgemein üblich bei längeren Leitungen, eine gewisse Eigenkapazität aufweist (in FIG 4 nicht dargestellt). Die gemeinsame Leitung L ist also, ähnlich einem Kondensator, auf ein festes Potential, z.B. auf das Potential VDD oder VSS, vorladbar. Sie ist außerdem mit einer Diskriminatorschaltung DISC verbunden. Die Diskriminatorschaltung DISC dient der Erkennung des Ladezustandes der gemeinsamen Leitung L.

In einer weiteren Ausführung der Erfindung, dargestellt in FIG 4, ist die gemeinsame Leitung L mit einer Stützkapazität CL verbunden. Die Stützkapazität CL ist ihrerseits wiederum mit einem der festen Potentiale VDD;VSS verbunden. Die Stützkapazität CL hat in Betrieb eine unterstützende Wirkung hinsichtlich der Vorladbarkeit der gemeinsamen Leitung L, da sie die Wirkung der genannten Eigenkapazität fördert.

Die gemeinsame Leitung L ist in jeder logischen Einheit LU über den stromführenden Pfad (= Kanal bei MOS-Transistoren) eines dritten Transistors T3 mit dem ersten Anschluß des Ladekondensators C verbunden. Die dritten Transistoren T3 sind durch ein zweites Betriebsarten-Auswahlsignal 03 gesteuert, so daß sie schaltbar sind. Diese Anordnung ermöglicht den Vergleich von i Daten miteinander (i = Anzahl der logischen Einheiten LU) im Sinne einer logischen Verknüpfung als eine dritte Betriebsart MOD3 der erfindungsgemäßen integrierten Halbleiterschaltung.

Die dritte Betriebsart MOD3 ermöglicht als logische Verknüpfung je nach schaltungstechnischer Auslegung des Blockes logischer Einheiten LU (dritte Transistoren T3: p- oder n-Kanal-Transistoren; zweites Betriebsarten-Auswahlsignal 03 in Abhängigkeit vom Kanaltyp der dritten Transistoren T3 "positive-going" oder "negative-going"; gemeinsame Leitung L vorladen auf Versorgungspotential VDD oder Masse VSS der integrierten Halbleiterschaltung; Dimensionierung der Diskriminatorschaltung DISC) folgende Boole'sche Operationen: AND, OR, NAND, NOR. Hinsichtlich weiterer Informationen über die Arbeitsweise und nähere Ausgestaltung der Diskriminatorschaltung DISC sowie einer möglichen Vorladeeinrichtung für die gemeinsame Leitung L wird auf die anmeldereigene ältere, nicht vorveröffentlichte Internationale Anmeldung WO 88/07292 verwiesen.

Im folgenden wird die Betriebsweise kurz erläutert: Zunächst werden durch Aktivieren einer ausgewählten Wortleitung WL die in allen an die Wortleitung WL angeschlossenen Speicherzellen MC gespeicherten Daten Ai über die jeweils zugehörige Bitleitung BL gelesen und mittels den zugeordneten Bewerterschaltungen AMPL bewertet und verstärkt. Danach weisen alle Bitleitungen BLi an je einer ihrer Bitleitungshälften BLH,BLH - - (beipielsweise an den einen Bitleitungshälften BLH) dasjenige logische Datum A auf, das über die jeweilige Bitleitung BL aus der der Wortleitung WL zugeordneten Speicherzelle MC ausgelesen worden ist. Durch Aktivieren desjenigen ersten Betriebsarten-Auswahlsignales 01,02 (im Beispiel 01) gelangen die Daten Ai parallel über den dem aktivierten ersten Betriebsarten-Auswahlsignal (01 angenommen) zugeordneten Transistor (z.B. T1) auf die ersten Anschlüsse der Ladekondensatoren C und laden bzw. entladen diese je nach Wert des betreffenden Datums A (log. 1 bzw. log. 0), wobei vorteilhafterweise das aktivierte eine erste Betriebsarten-Auswahlsignal (01 war angenommen) aktiviert bleibt, um die Bewerterschaltungen AMPL elektrisch leitend mit den Ladekondensatoren C verbunden zu halten. Es ist jedoch auch möglich, das eine erste Betriebsarten-Auswahlsignal 01 zu deaktivieren.

Die gemeinsame Leitung L ist spätestens jetzt auf eines der festen Potentiale VDD,VSS vorzuladen. Bei Verwendung der Stützkapazität CL ist diese mit einem der festen Potentiale VDD, VSS verbunden.

Nachstehend sind einige nach diesem Verfahren mittels der vorliegenden Anordnung möglichen logischen Vergleiche beschrieben: AND-Vergleich: Die gemeinsame Leitung L sei auf das feste Potential VDD vorgeladen (VDD entspreche beispielsweise wertemäßig dem Pegel eines Datums "log. 1 "). Nun wird das zweite Betriebsarten-Auswahlsignal03 aktiviert. Wurde zuvor an allen Ladekondensatoren C ein Datum A mit dem Wert "log. 1 " gespeichert, was wertemäßig gleich dem Wert des festen Potentials VDD sei, so sind alle dritten Transistoren T3 gesperrt (n-Kanal-Transistoren seien angenommen); die gemeinsame Leitung L bleibt vorgeladen. Dies erkennt die Diskrininatorschaltung DISC; sie gibt an ihrem Ausgang 0 ein entsprechendes Signal ab, das in diesem Fall anzeigt, daß das Ergebnis der logischen Verknüpfung "AND" gleich "log. 1 " ist.

Wurde jedoch an wenigstens einem der Ladekondensatoren C eine logische 0 als Datum A gespeichert, was wertemäßig gleich dem Wert des festen Potentials VSS sei, so leitet der diesem wenigstens einen Ladekondensator C zugeordnete dritte Transistor T3, was zu einem Absinken des Potentials der gemeinsamen Leitung L führt. Dies wiederum erkennt die Diskriminatorschaltung DISC; sie gibt an ihrem Ausgang 0 ein zum obengenannten Signal komplementäres Signal ab, das anzeigt, daß das Ergebnis der logischen Verknüpfung "AND" gleich "log. 0" ist.

Je nach Wahl des Pegels des Ausgangssignales 0 der Diskriminatorschaltung DISC für den Fall des Vorliegens einer log. 1 an allen Ladekondensatoren C lassen sich somit sowohl ein AND- wie auch ein NAND-Vergleich realisieren.

Wird die gemeinsame Leitung L auf den Wert des festen Potentials VSS (= Masse) vorgeladen, so lassen sich je nach Wahl des Wertes des Signales am Ausgang 0 der Diskriminatorschaltung DISC für den Fall, in dem alle an den Ladekondensatoren C gespeicherten Daten gleich log. 0 sind, die Funktionen OR bzw. NOR als dritte Betriebsart MOD3 (d.h. logischer Vergleich) erzielen. Der Fachmann kann dies leicht nachvollziehen anhand der obigen Ausführungen zu AND-/NAND-Vergleichen. Es ist auch günstig, zum Aktivieren des zweiten Betriebsarten-Auswahlsignales 03 einen Pegel vorzusehen, der wertemäßig zwischen den festen Potentialen VSS und VDD liegt. Im übrigen wird in diesem Zusammenhang nochmals auf die anmeldereigene ältere, nicht vorveröffentlichte Internationale Anmeldung WO 88/07292 hingewiesen, deren Offenbarung, soweit relevant, Bestandteil der vorliegenden Beschreibung ist. Insbesondere ist in der genannten Anmeldung auch eine Anordnung offenbart, die es ermöglicht, in Betrieb wahlweise die logischen Vergleiche AND,NAND,OR,NOR durchzuführen.

Soll mit der Anordnung nach FIG 4 jedoch die zweite Betriebsart MOD2 durchgeführt werden, so sind die dritten Transistoren T3 ständig gesperrt zu halten, d.h. das zweite Betriebsarten-Auswahlsignal 03 ist stets inaktiv zu halten.

Eine weitere vorteilhafte Ausführungsform der Erfindung ist in FIG 5 dargestellt. FIG 5 zeigt außer den bereits beschriebenen Merkmalen noch folgende Merkmale je logischer Einheit LU:
Zwischen den Drains der ersten beiden Transistoren T1,T2, die der Dateninversion dienen, und jeder der beiden Bitleitungshälften BLH;BLH einer Bitleitung BL sind je ein erster Transfertransistor TT1;TT11 und ein zweiter Transfertransistor TT2;TT12 mit ihren stromführenden Pfaden (bei MOS-Transistoren: = Kanälen) in Serie hintereinander angeordnet. Die Gates der beiden zweiten Transfertransistoren TT2;TT12 sind jeweils mit einem von zwei dritten Betriebsarten-Auswahlsignalen 04;05 verbunden. Das Gate des einen ersten Transfertransistors TT1 ist mit der anderen Bitleitungshälfte BLH verbunden. Das Gate des anderen ersten Transfertransistors TT11 ist mit der einen Bitleitungshälfte BLH verbunden.

Diese Ausführungsform ermöglicht ein ein- bis mehrmaliges Ausführen der Boole'schen Operationen XNOR,OR und NAND je Bitleitung BL als vierte Betriebsart MOD4. Bei einer einmaligen Ausführung wird ein einzelnes aus einer Speicherzelle MC ausgelesenes, bewertetes Datum A mit einem an die betreffende logische Einheit LU anzulegenden Vergleichsdatum X mittels der gewünschten Boo- le'schen Operation verglichen. Es werden also zwei Bits miteinander verglichen. Bei einer mehrmaligen Ausführung werden mehrere nacheinandere aus mehreren Speicherzellen MC entlang einer einzigen Bitleitung BL ausgelesene, bewertete Daten Ap (p = Anzahl der Daten) mit mehreren nacheinander an die betreffende logische Einheit LU anzulegenden Vergleichsdaten Xp mittels der gewünschten Boole'schen Operationen verglichen (wortweiser Vergleich).

Im einzelnen hat die vierte Betriebsart MOD4 folgenden Verlauf: Zu Beginn werden die Ladekondensatoren C aller logischen Einheiten LU auf das feste Potential VDD aufgeladen (dessen Wert entspreche wiederum dem Wert des Pegels log. 1). Das Aufladen kann entweder über die gemeinsame Leitung L und die dazugehörigen dritten Transistoren T3 erfolgen oder über die Bitleitungen BL. In letzterem Fall werden die Bewerterschaltungen AMPL in einen beliebigen Bewertungszustand gebracht, wodurch jeweils an einer der Bitleitungshälften BLH,BLH eine log. 1 liegt. Die Mittel dazu sind dem Fachmann geläufig. Je logischer Einheit LU wird nun derjenige der beiden ersten Transistoren T1,T2, der mit derjenigen Bitleitungshälfte BLH,BLH verbunden ist, an der die log. 1 anliegt, mittels des ihm zugeordneten einen bzw. anderen der beiden ersten Betriebsarten-Auswahlsignale 01;02 leitend geschaltet. Somit gelangt die log. 1 als festes Potential VDD auf jeden Ladekondensator C; diese sind vorgeladen. Anschließend bleiben beide ersten Betriebsarten-Auswahlsignale 01,02, ebenso wie das zweite Betriebsarten-Auswahlsignal 03, deaktiviert.

Für die nachfolgenden Vorgänge wird eine einzige Bitleitung BL mit der daran angeschlossenen logischen Einheit LU betrachtet; die entsprechenden Vorgänge an den restlichen Bitleitungen BL und logischen Einheiten LU bleiben unberücksichtigt.

In bekannter Weise wird jetzt ein Datum A, das in einer mit der Bitleitung BL verbundenen, durch eine Wortleitung WL adressierten Speicherzelle MC gespeichert ist, ausgelesen und mittels der Bewerterschaltung AMPL bewertet und verstärkt. Nachfolgend sei angenommen, daß das Datum A auf der einen Bitleitungshälfte BLH anliege. Somit liegt an der anderen Bitleitungshälfte BLH ein zum Datum A komplementäres Datum Ä an. Nun nehmen das eine dritte Betriebsarten-Auswahlsignal 04 den Wert des Vergleichsdatums X an und das andere dritte Betriebsarten-Auswahlsignal 05 den Wert eines zum Vergleichsdatum X komplementären Vergleichsdatums X an.

Sind das ausgelesene, bewertete Datum A und das Vergleichsdatum X gleich, so sind entweder der eine erste Transfertransistor TT1 und der andere zweite Transfertransistor TT12 gesperrt (Datum A = Vergleichsdatum X = log. 1) oder der andere erste Transfertransistor TT11 und der eine zweite Transfertransistor TT2 gesperrt (Datum A = Vergleichsdatum X = log. 0). In beiden Fällen bleibt somit die auf dem Ladekondensator C gespeicherte logische 1 (= festes Potential VDD) erhalten. Am Ladekondensator C liegt also das Ergebnis der Boole'schen Operation "Datum A XNOR Vergleichsdatum X" = "log. 1 XNOR log. 1 " bzw. "log. 0 XNOR log. 0" = "log. 1 " an.

Sind jedoch das ausgelesene, bewertete Datum A und das Vergleichsdatum X ungleich, so sind entweder sowohl der eine erste Transfertransistor TT1 und der eine zweite Transfertransistor TT2 (Datum A = log. 0; Vergleichsdatum X = log. 1) oder der andere erste Transfertransistor TT11 und der andere zweite Transfertransistor TT12 (Datum A = log. 1; Vergleichsdatum X = log. 0) leitend. In jedem dieser beiden Fälle wird diejenige Bitleitungshälfte BLH,BLH, die den Zustand log. 0 (= festes Potential VSS = Masse) aufweist (weil entweder Datum A = log. 0 oder komplementäres Datum Ä = log. 0), über die genannten leitenden Transfertransistoren mit der ersten Elektrode des Ladekondensators C verbunden; dieser wird somit entladen auf das feste Potential VSS = Masse.

Auf diese Weise wurde ein gespeichertes Bit (Datum A) mit einem Vergleichsbit X verglichen.

Wiederholt man die vorgenannten Schritte (mit Ausnahme des Schrittes "Vorladen des Ladekondensators C auf das feste Potential VDD") mehrmals hintereinander, so lassen sich mehrere (in verschiedenen Speicherzellen MC entlang der einen Bitleitung BL gespeicherte) Daten Ap (zeitlich hintereinander) mit mehreren Daten Xp vergleichen (z.B. Boole'sche Operation XNOR); das Endergebnis ist durch den Endzustand des Ladekondensators C bestimmt (der zwischendurch nie mehr auf das feste Potential VDD geladen wird). Dieses Endergebnis ist über einen der beiden ersten Transistoren T1,T2 und das entsprechende erste Betriebsarten-Auswahlsignal 01,02 an die Bewerterschaltung AMPL anlegbar und durch diese bewertbar, so daß es an der Bewerterschaltung AMPL stabil zur Verfügung steht und beispielsweise über einen Datenausgang des Speicherbereiches MEM auslesbar ist. Auf diese Weise läßt sich sehr schnell innerhalb der integrierten Halbleiterschaltung beispielsweise ein in Speicherzellen MC entlang einer Bitleitung BL gespeichertes Wort (Daten Ap) mit einem in Wortform vorliegenden Suchbegriff (Vergleichsdaten Xp) vergleichen. Der Vergleich selbst erfolgt für alle Bitleitungen BL zeitgleich parallel. Die Ergebnisse an jeder einzelnen Bitleitung BL sind hintereinander von den einzelnen Bewerterschaltungen AMPL beispielsweise über den obengenannten Datenausgang durch Anlegen der einzelnen Bitleitungsadressen auslesbar.

Es lassen sich mit der vorliegenden Ausgestaltung jedoch auch die logischen Operationen OR und NAND durchführen:

### a) OR-Operation:

Die vierte Betriebsart MOD4 wird ausgeführt wie zuvor anhand der XNOR-Operation beschrieben mit folgender Ausnahme: Bei Anliegen des Datums A auf der einen Bitleitungshälfte BLH wird das eine dritte Betriebsarten-Auswahlsignal 04 mit einem Datum X verbunden, das zum Vergleichsdatum X komplementär ist; das andere dritte Betriebsarten-Auswahlsignal 05 ist stets deaktiviert. Weist das Vergleichsdatum X den Wert log. 1 auf, so sind beide zweite Transfertransistoren TT2,TT12 stets gesperrt; am Ladekondensator C bleibt die Vorladung erhalten, was als Ergebnis bedeutet: log. 1. Weist das Vergleichsdatum X hingegen den Wert log. 0 auf, so ist der eine zweite Transfertransistor TT2 stets leitend wegen des Datums X. Der eine erste Transfertransistor TT1 ist dagegen genau dann leitend, wenn das Datum A den Wert log. 0 aufweist; in diesem Fall wird der Ladekondensator C auf log.0 = festes Potential VSS entladen. Ansonsten ist der eine erste Transfertransistor TT1 gesperrt, wodurch der Ladekondensator C geladen bleibt.

### b) NAND-Operation:

Im Gegensatz zur OR-Operation ist das eine dritte Betriebsarten-Auswahlsignal 04 stets deaktiviert, während am anderen dritten Betriebsarten-Auswahlsignal 05 das Vergleichsdatum X liegt. Der Ladekondensator C wird nur in dem Fall auf log. 0 entladen, wenn sowohl das Datum A (bei dem wiederum angenommen sei, daß es an der einen Bitleitungshälfte BLH anliege) wie auch das Datum X gleich log. 1 sind. Ansonsten sind immer wenigstens einer der ersten und einer der zweiten Transfertransistoren TT1,TT11, TT2,TT12 gesperrt.

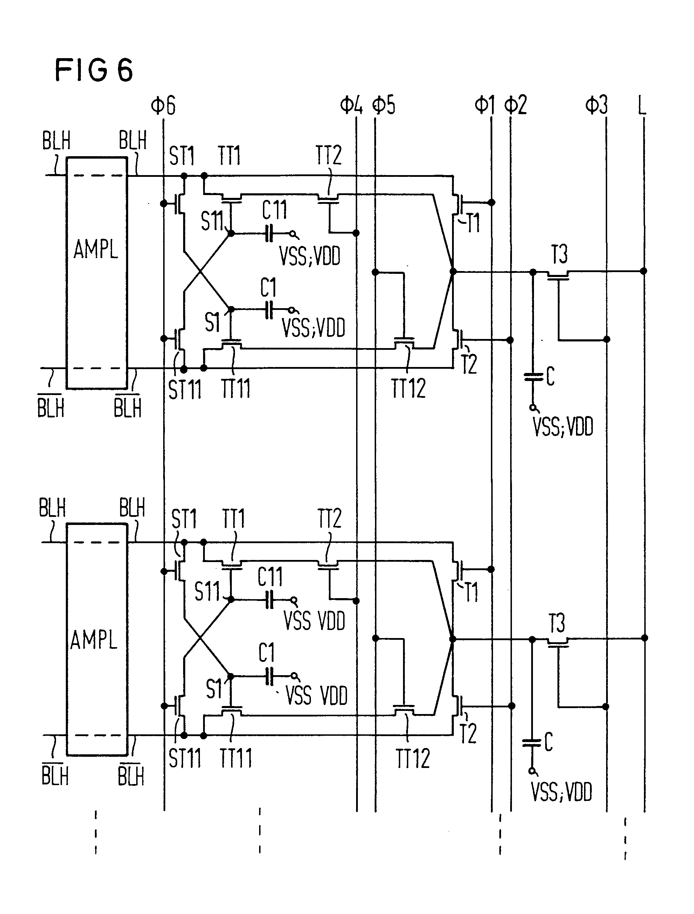

FIG 6 zeigt eine weitere vorteilhafte Ausgestaltung der Erfindung. Sie unterscheidet sich von der Ausgestaltung nach FIG 5 durch folgende Merkmale:
Die Gates der beiden ersten Transfertransistoren TT1,TT11 sind zusätzlich mit den ersten Elektroden zweier zwischenspeichernder Kapazitäten C1,C11 unter Bildung zweier Speicherknoten S1,S11 verbunden. Die zweiten Elektroden der beiden zwischenspeichernden Kapazitäten C1,C11 sind mit einem der beiden festen Potentiale VSS,VDD verbunden. Weiterhin sind zwischen den beiden Speicherknoten S1;S11 und den entsprechenden Bitleitungshälften BLH;BLH Speichertransistoren ST1;ST11 mit ihren Kanälen angeordnet.
Deren Gates sind mit einem vierten Betriebsarten-Auswahlsignal 06 verbunden.

Diese Ausgestaltung ermöglicht das Betreiben der erfindungsgemäßen integrierten Halbleiterschaltung in einer fünften Betriebsart MOD5. In der fünften Betriebsart MOD5 sind verschiedene Operationen möglich, beispielsweise die Boole'schen Operationen AND,NAND,OR,NOR,XOR,XNOR. Dazu wird, jeweils parallel für den gesamten Block logischer Einheiten LU, an jede Bitleitungshälfte BLH (bzw. BLH) ein Vergleichsdatum X angelegt (beispielsweise, wie bereits beschrieben, an alle Bitleitungshälften BLH dasselbe Vergleichsdatum X über die gemeinsame Leitung L und dem einen ersten Transistor T1, oder über den Dateneingang des Halbleiterspeichers und die einzelnen Bewerterschaltungen AMPL; in letzterem Fall ist es möglich, an die verschiedenen Bitleitungshälften BLH verschiedene logische Werte des Vergleichsdatums X anzulegen). Die an den einzelnen Bitleitungshälften BLH anliegenden Vergleichsdaten X (bzw. Xi bei verschiedenen Vergleichsdaten) werden nun über die Bewerterschaltungen AMPL bewertet, so daß sich an den jeweils anderen Bitleitungshälften BLH ein zum Vergleichsdatum X komplementäres Datum X ausbildet (bekannte FlipFlop-Funktion der Bewerterschaltungen AMPL). Anschließend wird das vierte Betriebsarten-Auswahlsignal 06 aktiviert, so daß je Bitleitung BL das auf den Bitleitungshälften BLH,BLH anliegende Vergleichsdatum X bzw. das dazu komplementäre Datum X an die erste Elektrode des zugehörigen Speicherknotens S1;S11 gelangt und dort gespeichert wird. Danach wird das vierte Betriebsarten-Auswahlsignal 06 wieder deaktiviert.

Alternativ zu dieser Art, die Speicherknoten S1,S11 vorzuladen, ist es auch möglich, die Vergleichsdaten Xi parallel für alle Bitleitungen BL aus dem Speicherzellenfeld MCF her auszulesen. Dazu wird, wie üblich, eine bestimmte Wortleitung WL adressiert, so daß die in allen mit der Wortleitung WL verbundenen Speicherzellen MC gespeicherten Daten parallel zueinander auf die Bitleitungen BL gelangen und durch die Bewerterschaltungen AMPL bewertet und verstärkt werden. Das Abspeichern in den Speicherknoten S1,S11 erfolgt dann mittels des vierten Betriebsarten-Auswahlsignals 06, wie bereits beschrieben.

Nun werden die Ladekondensatoren C des Blockes logischer Einheiten LU auf das feste Potential VDD bzw. VSS vorgeladen, wie bei den zuvor beschriebenen Betriebsarten MODk bereits erläutert. Ab jetzt sind die eigentlichen logischen Operationen durchführbar.

Dies kann auf zwei verschiedene Arten erfolgen:
a) Bitleitungs-orientiert und
b) wortleitungs-orientiert.
a) Zunächst sei die bitleitungs-orientierte Art erläutert:

Die konkrete Aufgabenstellung dazu laute beispielsweise: Auf jedes in Speicherzellen MC an (ein und derselben) Bitleitung BL gespeicherte Datum A ist die Boole'sche Operation NAND mittels eines Vergleichsdatums X anzuwenden, wobei das Vergleichsdatum X für jedes Datum A einen anderen Wert aufweisen kann (d.h. eine Folge von Daten Ap (p = Anzahl der Wortleitungen WL) wird mit einem Datenwort Xp verglichen, das p verschiedene Vergleichsdaten X enthält).

Werden die Daten A über die eine Bitleitungshälfte BLH ausgelesen, so sind zur Durchführung der NAND-Operation das eine dritte Betriebsarten-Auswahlsignal 04 auf log. 0 konstant zu setzen und das andere dritte Betriebsarten-Auswahlsignal 05 auf log. 1. Werden die Daten A jedoch über die andere Bitleitungshälfte BLH ausgelesen, so sind zur Durchführung der NAND-Operation das eine dritte Betriebsarten-Auswahlsignal 04 auf log. 1 konstant zu setzen und das andere dritte Betriebsarten-Auswahlsignal 05 auf log. 0. Die eigentliche Boole'sche Operation wird nun analog ausgeführt wie hinsichtlich der vierten Betriebsart MOD4 zuvor bereits beschrieben mit folgenden wesentlichen Unterschieden:
1.) Die dritten Betriebsarten-Auswahlsignale 04,05 weisen ihre oben angegebenen Werte log. 0 bzw. log. 1 konstant auf; sie wirken als echte Steuersignale und nicht als Vergleichsdatum X bzw. dazu komplementäres Datum X, wie in der vierten Betriebsart MOD4. Infolgedessen sind der eine zweite Transfertransistor TT2 stets gesperrt und der andere zweite Transfertransistor TT12 stets leitend.
2.) Ist der logische Vergleich so auszuführen, daß jedes auszulesende Datum A mit einem (anderen) Wert des Vergleichsdatums X (im Sinne des obengenannten Datenwortes Xp) zu vergleichen ist, so ist das entsprechende Vergleichsdatum X des Datenwortes Xp auf den Speicherknoten S1 (bzw. S11) abzuspeichern, bevor das entsprechende Datum A ausgelesen und bewertet wird. Sind die verschiedenen Daten Ap jedoch jeweils mit ein und demselben Vergleichsdatum X zu vergleichen, so braucht letzteres nur einmal (d.h. vor Beginn des Auslesevorganges für das erste Datum A) abgespeichert zu werden.

Nähere Erläuterungen sind für den Fachmann anhand der Parallelen zur bereits beschriebenen vierten Betriebsart MOD4 nicht nötig. Es wird jedoch darauf hingewiesen, daß die Ladezustände der einzelnen Ladekondensatoren C (d.h. also, das Ergebnis der logischen Operationen) über die der jeweiligen logischen Einheit LU zugeordnete Bitleitung BL in Speicherzellen MC des Speicherzellenfeldes MCF abspeicherbar sind.

Ein Ausführen der Boole'schen Operation AND erfolgt in der Weise, daß zunächst die Boole'sche Operation NAND ausgeführt wird und deren Endergebnis (d.h. der Ladezustand am ersten Anschluß des Ladekondensators C) mittels der bereits beschriebenen zweiten Betriebsart MOD2 invertiert wird.

Zur Durchführung der Boole'schen Operation OR werden die an die dritten Betriebsarten- Auswahlsignale 04,05 gegenüber der zuvor beschriebenen NAND-Operation vertauscht (d.h. also im Beispiel, daß das eine dritte Betriebsarten-Auswahlsignal 04 konstant log. 1 aufweist und das andere dritte Betriebsarten-Auswahlsignal 05 konstant log. 0).

Die NOR-Operation wird, analog zur bereits beschriebenen AND-Operation, ausgeführt, indem zunächst die OR-Operation als fünfte Betriebsart MOD5 ausgeführt wird und anschließend daran die zweite Betriebsart MOD2 (Invertieren).

Entsprechendes gilt für die XOR-Operation: Dazu sind beide dritten Betriebsarten-Auswahlsignale 04,05 auf log. 1 zu halten; die XNOR-Funktion wird durch Anwenden der zweiten Betriebsart MOD2 nach Ausführen der fünften Betriebsart MOD5 erzielt.

### b) Nunmehr sei die wortleitungsorientierte Art der fünften Betriebsart MOD5 erläutert:

Die konkrete Aufgabenstellung hierzu laute beispielsweise: Auf jedes in Speicherzellen MC an (ein und derselben) Wortleitung WL gespeicherte Datum A ist die Boole'sche Operation NAND mittels eines Vergleichsdatums X anzuwenden, wobei an jeder logischen Einheit LU ein anderes Vergleichsdatum X (gleichzeitig) anliegen kann (d.h. also, am gesamten Block logischer Einheiten LU liegt ein komplettes Vergleichswort Xi mit i = Gesamtzahl der Anzahl logischer Einheiten LU). Die einzelnen Vergleichsdaten X werden zunächst in bereits beschriebener Weise in den Speicherknoten S1,S11 abgespeichert. Dann werden, falls noch nicht erfolgt, die Ladekondensatoren C der logischen Einheiten LU auf das feste Potential VDD bzw. VSS vorgeladen.

Jetzt wird eine bestimmte Wortleitung WL adressiert, die in den damit verbundenen Speicherzellen MC gespeicherten Daten A werden auf die Bitleitungen BL ausgelesen und durch die Bewerterschaltungen AMPL bewertet und verstärkt. Die dritten Betriebsarten-Auswahlsignale 04,05 nehmen nun die unter Punkt a) der fünften Betriebsart MOD5 bereits beschriebenen Werte an (NAND/AND-Operation: 04 = log. 0, 05 = log. 1; OR/NOR-Operation: 04 = log. 1, 05 = log. 0; XOR/XNOR-Operation: 04 = 05 = log. 1; jeweils bei Auslesen des Datums A auf die eine Bitleitungshälfte BLH).

Dadurch werden bei jeder logischen Einheit LU das auf der jeweiligen Bitleitungshälfte BLH anliegende Datum A mit dem in dem jeweiligen Speicherknoten S1 gespeicherten Vergleichsdatum X (bzw. das auf der anderen Bitleitungshälfte BLH liegende komplementäre Datum Ä mit dem im jeweiligen Speicherknoten S11 gespeicherten komplementären Datum X) entsprechend den angelegten dritten Betriebsarten-Auswahlsignalen 04,05 verglichen. Das bei jeder einzelnen logischen Einheit LU aus dem Vergleich resultierende Ergebnis der Boole'schen Operation (im gewählten Beispiel: NAND-Operation) bestimmt, analog zu den bereits beschriebenen Betriebsarten, den Potentialzustand des jeweiligen Ladekondensators C. Dieses Ergebnis ist wiederum, wie ebenfalls bereits beschrieben, invertierbar (zweite Betriebsart MOD2), über die Bewerterschaltungen AMPL und den Datenausgang des Halbleiterspeichers auslesbar sowie im Speicherzellenfeld MCF abspeicherbar. Außerdem ist auf die Ladekondensatoren C des gesamten Blokkes logischer Einheiten LU parallel die dritte Betriebsart MOD3 anwendbar.

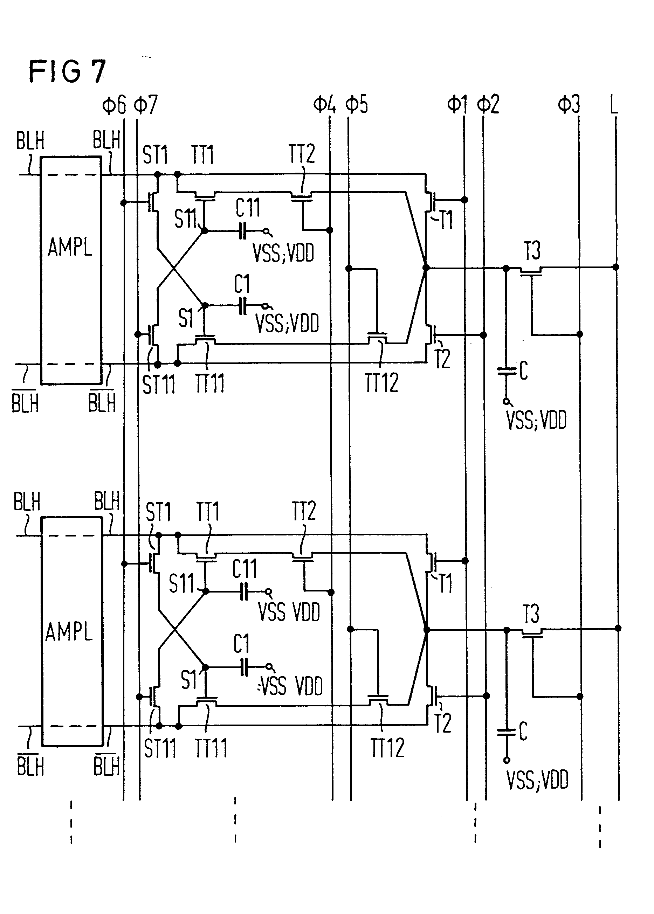

Die Ausführungsform nach FIG 7 unterscheidet sich von der nach FIG 6 dadurch, daß sie anstelle eines einzigen vierten Betriebsarten-Auswahlsignales 06 zwei voneinander unabhängig ansteuerbare vierte Betriebsarten-Auswahlsignale 06,07 aufweist. Das eine vierte Betriebsarten-Auswahlsignal 06 ist bei jeder logischen Einheit LU mit dem Gate des einen Speichertransistors ST1 verbunden. Das andere vierte Betriebsarten-Auswahlsignal 07 ist dagegen bei jeder logischen Einheit LU mit dem Gate des anderen Speichertransistors ST11 verbunden. Mit dieser Ausführungsform ist die zuvor beschriebene fünfte Betriebsart MOD5 möglich mit ihren einzelnen verschiedenen Operationen unter Verwendung von "Maskierbits": Soll eine (oder mehrere) bestimmte logische Einheit LU aus dem Block logischer Einheiten LU zur Durchführung der fünften Betriebsart MOD5 nicht verwendet werden (d.h. z.B., daß der Ladezustand ihres Ladekondensators C unabhängig von irgendwelchen Daten unverändert erhalten bleiben soll), so ist in beiden Speicherknoten S1,S11 der logischen Einheit LU ein Wert abzuspeichern, der beide erste Transfertransistoren TT1, TT11 sicher sperrt (im Falle von n-Kanal-Transistoren also "log. 0"). Damit kann der Ladekondensator C nicht entladen werden.

Die beiden Bitleitungshälften BLH,BLH, über die das Vergleichsdatum X (und das dazu komplementäre Datum X) in die Speicherknoten S1,S11 geladen wird, weisen bekanntlich stets zueinander komplementäre elektrische Zustände auf. Durch Aktivieren des vierten Betriebsarten-Auswahlsignales 06 in FIG 6 können also nicht beide Speicherknoten S1,S11 gleichzeitig denjenigen gleichen Wert abspeichern, der beide erste Transfertransistoren TT1,TT11 sperrt. Durch Verwendung zweier verschiedener, voneinander unabhängiger Betriebsarten-Auswahlsignale 06,07ist dies jedoch erreichbar: Unter der Annahme, daß der abzuspeichernde Wert "log. 0" beide ersten Transfertransistoren TT1, TT11 sperrt, wird folgendermaßen verfahren:
Zunächst wird die eine Bitleitungshälfte BLH (mit bekannten, bereits beschriebenen Maßnahmen) mit dem Wert "log. 0" belegt. Dann wird das eine vierte Betriebsarten-Auswahlsignal 06 aktiviert, so daß die angelegte "log. 0" an den einen Speicherknoten S1 gelangt. Durch anschließendes Deaktivieren des einen vierten Betriebsarten-Auswahlsignales 06 bleibt die "log. 0" auf dem einen Speicherknoten S1 gespeichert, der damit verbundene andere erste Transfertransistor TT11 bleibt sicher gesperrt.

Anschließend daran wird die andere Bitleitungshälfte BLH mit dem Wert "log. 0" belegt. Dann wird das andere vierte Betriebsarten-Auswahlsignal 07 aktiviert, so daß die angelegte "log. 0" an den anderen Speicherknoten S11 gelangt. Durch anschließendes Deaktivieren des anderen vierten Betriebsarten-Auswahlsignales 07 bleibt die "log. 0" auf dem anderen Speicherknoten S11 gespeichert, der damit verbundene eine erste Transfertransistor TT1 bleibt ebenfalls sicher gesperrt.

Sollen bei einer Ausgestaltung nach den FIG 6 oder 7 die Betriebsarten MOD3 oder MOD4 ausgeführt werden, so sind die vierten Betriebsarten- Auswahlsignale 06,07 konstant aktiviert zu halten. Auf eine Durchführung der zweiten Betriebsart MOD2 ist der Zustand der vierten Betriebsarten- Auswahlsignale 06,07 ohne Einfluß, weil die dritten Betriebsarten-Auswahlsignale 04,05deaktiviert sind. Zur Durchführung der ersten Betriebsart MOD1 sind, wie bereits beschrieben, alle Betriebsarten- Auswahlsignale 0j inaktiv zu halten.

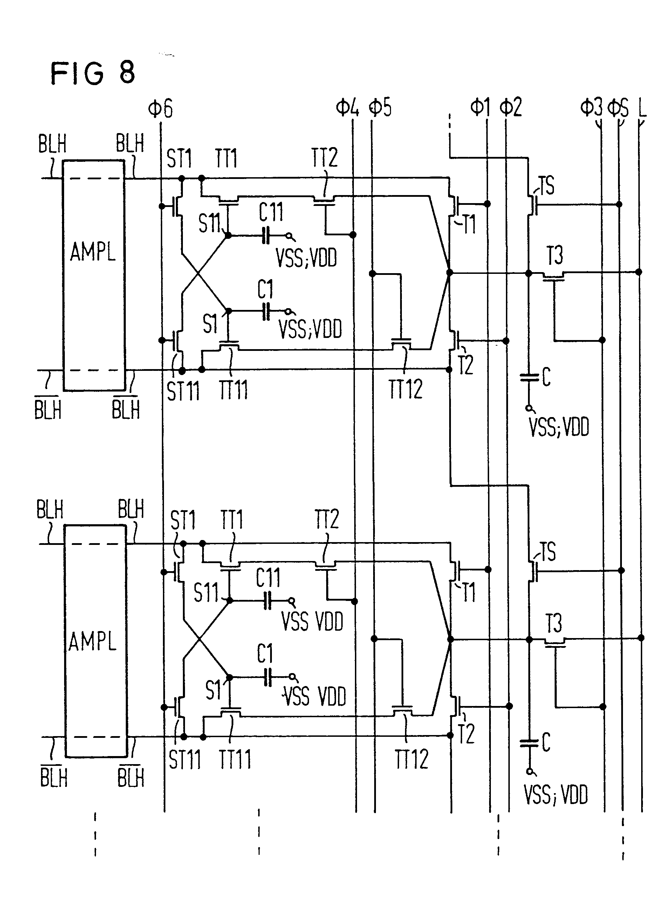

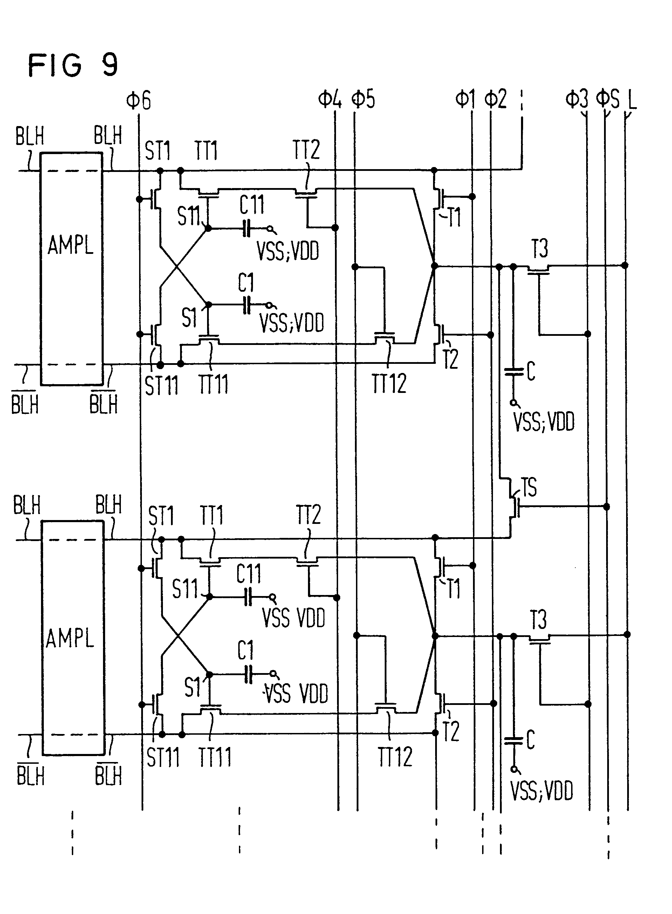

Die FIG 8 und 9 zeigen weitere mögliche Ausgestaltungen der Erfindung. Sie ermöglichen Addition und Subtraktion von Daten Ai, die in Speicherzellen MC entlang einer Wortleitung WL gespeichert sind und aus dieser (parallel) ausgelesen und bewertet werden, mit bzw. von Vergleichsdaten Xi, die in den Speicherknoten S1 gespeichert sind. Sie ermöglichen weiterhin Multiplikation und Division, da diese bekanntlich lediglich ein mehrmaliges Ausführen von Addition bzw. Subtraktion sind. Diese arithmetischen Operationen sind eine sechste Betriebsart MOD6 der erfindungsgemäßen Schaltung. Verglichen mit der Ausführungsform nach FIG 7 weisen die Schaltungen nach den FIG 8 und 9 zusätzlich jeweils einen Schiebetransistor TS auf, der mit seinem stromführenden Pfad (= Kanal) zwischen dem ersten Anschluß des Ladekondensators C einer logischen Einheit LU und der in der Reihenfolge der einzelnen logischen Einheiten LU vorhergehenden (FIG 8) bzw. nachfolgenden (FIG 9) Bitleitung BL angeordnet ist. Ob die Anbindung an die eine (BLH) oder an die andere Bitleitungshälfte BLH erfolgt, ist für die ausführbaren Funktionen, prinzipiell gesehen, ohne Belang. Die Schiebetransistoren TS sind an ihren Gates gemeinsam mit einem Schiebesignal 0S verbunden, das als fünftes Betriebsarten-Auswahlsignal wirkt. Diese Anordnung ermöglicht eine Schieberegisterfunktion: Das an einem Ladekondensator C gespeicherte Potential ist damit an die entsprechende benachbarte Bitleitung BL weiterschiebbar und von dieser aus über einen der beiden Transistoren T1,T2 weiterschiebbar an den damit verbundenen Ladekondensator C.

Bei der Ausführungsform nach FIG 8 liegt das "most significant bit" des einen Operanden (beispielsweise der Daten Ai) an der in einer betrachteten Reihenfolge (von oben nach unten) der Bitleitungen BL ersten Bitleitung. Hingegen liegt bei der Ausführungsform nach FIG 9 das "most significant bit" an der in der betrachteten Reihenfolge letzten Bitleitung BL.

Prinzipiell läuft die Addition folgendermaßen ab: Zunächst wird der eine Operand (je logischer Einheit LU ein Vergleichsdatum X) in die einen Speicherknoten S1 (bzw. S11) der logischen Einheiten LU gespeichert. Dann wird der andere Operand (je Bitleitung als Datum A) parallel aus allen mit einer bestimmten, adressierten Wortleitung WL verbundenen Speicherzellen MC ausgelesen, bewertet und verstärkt. Beide Operanden werden nun, wie als vierte Betriebsart MOD4 bereits beschrieben, mittels der Boole'schen Operation XOR miteinander verknüpft (dies entspricht einer sog. "Halbaddition"); das Ergebnis ist durch den sich einstellenden Ladezustand jedes einzelnen Ladekondensators C gegeben. Dieses Ergebnis wird nun unter Adressierung einer anderen Wortleitung WL in das Speicherzellenfeld MCF zurückgeschrieben. Anschließend wird die ursprünglich adressierte Wortleitung WL nochmals adressiert, wodurch die dort gespeicherten Daten A (nochmals) an die Bitleitungen BL gelangen. Jetzt wird die Boole'sche Operation AND als vierte Betriebsart MOD4 ausgeführt für die Daten A und die (noch gespeicherten) Vergleichsdaten X. Damit ergibt sich je logischer Einheit LU der sog. Übertrag ("Carry-Bit") am Ladekondensator C. Durch Aktivieren des Schiebesignals 0S wird dieser Übertrag nun auf die benachbarte Bitleitung weitergeschoben, auf dieser mittels der Bewerterschaltung AMPL bewertet und verstärkt. Das Schiebesignal 0S wird wieder deaktiviert. Die so behandelten Überträge werden nun in den einen Speicherknoten S1 der jeweiligen logischen Einheit LU abgespeichert. Nun wird diejenige Wortleitung adressiert, mittels derer das Ergebnis der zuvor beschriebenen XOR-Operation abgespeichert wurde. Dieses wird wieder auf die Bitleitungen ausgelesen, bewertet, verstärkt und mittels der vierten Betriebsart MOD4 der Boole'schen Operation XOR hinsichtlich des in den Speicherknoten S1 gespeicherten Übertrages unterzogen. Deren Ergebnis ist dann das Gesamtergebnis der Addition.

Bei der Subtraktion wird zunächst die zweite Betriebsart MOD2 (Invertieren) ausgeführt und anschließend die sechste Betriebsart MOD6. Durch mehrmaliges Ausführen der Subtraktion ist auch eine Division möglich.

Besonders vorteilhaft ist es, wenn bei der in der Reihenfolge ersten logischen Einheit LU der erste Anschluß des Ladekondensators C über den Schiebetransistor TS mit der in der Reihenfolge letzten Bitleitung BL verbunden ist oder wenn bei der in der Reihenfolge letzten logischen Einheit LU der erste Anschluß des Ladekondensators C über den Schiebetransistor TS mit der in der Reihenfolge ersten Bitleitung verbunden ist. Mit diesen Ausführungsformen sind dann die sog. Modulo-Addition und Modulo-Subtraktion möglich.

Die zwischenspeichernden Kapazitäten C1,C11 müssen nicht unbedingt in Form separater Schaltelemente realisiert sein. Dazu ist es vorteilhaft, die parasitären Kapazitätseffekte der ersten Transfertransistoren TT1,TT11 (z.B. deren Gateoxid-Kapazitäten) auszunutzen.

Weiterhin ist es vorteilhaft, wenn die Ladekondensatoren C durch statische Speicherzellen ersetzt sind.

Die Speicherzellen MC des Speicherzellenfeldes MCF können vorteilhafterweise vom Typ "dynamische Random-Access-Zelle" sein oder vom Typ "statische Random-Access-Zelle" oder vom nichtflüchtigen Typ (wie z.B. EPROM,EEPROM).

Die erfindungsgemäße integrierte Halbleiterschaltung bietet weiterhin durch Kombination der beschriebenen verschiedenen Betriebsarten MODk die Möglichkeit, noch weitere, nicht beschriebene Operationen ausführen zu können.

### Beschreibung für Vertragsstaaten : DE, FR, GB

Die vorliegende Erfindung betrifft eine integrierte Halbleiterschaltung nach dem Oberbegriff des Patentanspruches 1.

Bildverarbeitung, Musterverarbeitung und Verknüpfungen von Massendaten in Datenbanksystemen treten bei der modernen Datenverarbeitung zunehmend in den Vordergrund. Diesen Tätigkeiten ist gemeinsam, daß sehr große Datenmengen zu verarbeiten sind. Traditionelle Datenverarbeitungssysteme führen die Verarbeitung seriell durch. Dies erfordert einen hohen Zeitaufwand, weil beispielsweise beim Suchen nach einem bestimmten Begriff sehr viele Daten aus einem Speicherbereich serial ausgelesen werden müssen und im Prozessor mit dem Suchbegriff verglichen werden müssen, bis der gewünschte Begriff gefunden ist.

Eine Teillösung dieses Problems stellt der Einsatz inhaltsadressierbarer integrierter Halbleiterspeicher (CAM) dar. Dies hat jedoch zwei Nachteile: Zum einen weisen die derzeit erhältlichen CAM-Speicher eine gegenüber modernen verfügbaren RAM- bzw. ROM-Speicherbausteinen (1 MBit Speicherkapazit) sehr geringe Speicherkapazität auf (maximal 8kBit; vgl. IEEE Journal of Solid-State Circuits, Vol. SC-20, No. 5, Oktober 1985, Seiten 951 bis 956) und zum anderen können diese Speicherbausteine lediglich assoziative Funktionen ausführen, nicht jedoch andere digitale Funktionen (z.B. logische, arithmetische). CAM-Speicherbausteine sind außerdem nicht wie übliche RAM- bzw. ROM-Speicherbausteine betreibbar.

Eine weitere Teillösung stellt die Kombination spezieller Prozessoren mit Speicherbausteinen in Parallel-Computern dar ("Transputer"). Transputer jedoch sind teuer, aufwendig zu konfigurieren und nicht universell, d.h. für beliebige Einsatzzwecke verwendbar.

Ausschließlich für die benannten Staaten Deutschland, Frankreich, Großbritannien ist die nachveröffentlichte EP-A 0 278 391 Stand der Technik nach A. 54 (3) EPÜ. Sie offenbart die Merkmale des Oberbegriffs des für diese Staaten geltenden Anspruches 1.

Aufgabe der vorliegenden Erfindung ist es, einen üblichen Halbleiterspeicherbausteinmit möglichst wenig Aufwand so weiterzubilden, daß sein Einsatz den üblicherweise benötigten Zeitaufwand verringert und daß er möglichst universal einsetzbar ist.

Diese Aufgabe wird bei einer gattungsgemäßen Halbleiterschaltung gelöst durch die kennzeichnenden Merkmale des Patentanspruches 1. Vorteilhafte Aus- und Weiterbildungen sind in Unteransprüchen gekennzeichnet.

Die Erfindung wird im folgenden anhand der Zeichnung näher erläutert: Es zeigen
FIG 1 einen unmaßstäblichen, globalen Überblick über die Schaltung,
FIG 2 einen Ausschnitt daraus,
die FIG 3 bis 9 vorteilhafte Ausgestaltungen von einzelnen logischen Einheiten der Schaltung.

Gemäß FIG 1 enthält die integrierte Halbleiterschaltung außer einem als solchen bekannten Speicherbereich MEM einen Block logischer Einheiten LU. Der Speicherbereich MEM enthält ein oder mehrere Speicherzellenfelder MCF mit über Wortleitungen WL und Bitleitungen BL adressierbaren Speicherzellen MC. Er enthält weiterhin eine der Anzahl der Bitleitungen BL entsprechende Anzahl von Bewerterschaltungen AMPL. Jede Bewerterschaltung AMPL ist, wie in FIG 2 ausschnittsweise dargestellt, so mit einer Bitleitung BL verbunden, daß sie diese in zwei wenigstens annähernd gleiche Bitleitungshälften BLH, BLH aufteilt. Ob diese Aufteilung nach dem Open-Bitline-Konzept oder nach dem Folded-Bitline-Konzept erfolgt ist, ist unwichtig für die vorliegende Erfindung.

Die integrierte Halbleiterschaltung enthält weiterhin einen Block von logischen Einheiten LU. Jede logische Einheit LU ist mit einer Bitleitung BL über deren beide Bitleitungshälften BLH,BLH verbunden. Die Verbindung kann innerhalb oder außerhalb der jeweiligen logischen Einheit LU erfolgen, beispielsweise durch Weiterführung der Bitleitung BL bis zur betreffenden logischen Einheit LU, wie dargestellt.

Die logischen Einheiten LU dienen einer digitalen Verarbeitung von aus dem Speicherbereich MEM über die Bitleitungen BL ausgelesenen, in den Bewerterschaltungen AMPL bewerteten und verstärkten Daten A sowie von zu den Daten A komplementären Daten Ä, die bekanntlich beim Bewerte- und Verstärkungsvorgang entstehen. Unter "digitale Verarbeitung" wird dabei insbesondere verstanden: Logische Verknüpfung zweier Bits (OR,AND,etc.), Invertieren eines oder mehrerer Bits, logische Vergleiche von Worten miteinander, arithmetische Operationen. Der Block logischer Einheiten LU ist dazu in verschiedenen Betriebsarten MODk (k = 1...n) betreibbar. Der Auswahl der Betriebsarten MODk dienen Betriebsarten-Auswahlsignale 0j (j = 1...m).

Aufbau und Funktion der Erfindung sind nachstehend meist anhand einer einzelnen logischen Einheit LU beschrieben. Unabhängig davon werden jedoch alle logischen Einheiten LU des Blockes parallel zueinander betrieben.

In einer ersten Betriebsart MOD1 sind sämtliche Betriebsarten-Auswahlsignale 0j deaktiviert, wodurch alle logischen Einheiten LU ebenfalls deaktiviert sind. In Betrieb bleiben die ausgelesenen, bewerteten Daten A somit unverändert. Das Betriebsverhalten der integrierten Halbleiterschaltung ist also in der ersten Betriebsart MOD1 identisch mit dem eines vergleichbaren Halbleiterspeicherbausteins, der den Block logischer Einheiten LU nicht enthält. Die Halbleiterschaltung ist demzufolge elektrisch kompatibel mit einem entsprechenden Halbleiterspeicherbaustein.

In der Ausführungsform nach FIG 3 enthält jede logisch Einheit LU wenigstens zwei Transistoren T1,T2 und einen Ladekondensator C. Die Transistoren T1,T2 dienen einer Inversion der an den Bitleitungen BL anliegenden bewerteten Daten A. Die Drains der Transistoren T1,T2 sind gemeinsam mit einem ersten Anschluß des Ladekondensators C verbunden. Der zweite Anschluß des Ladekondensators C ist mit einem festen Potential verbunden. Es empfiehlt sich, als festes Potential eines der der Spannungsversorgung der integrierten Halbleiterschaltung dienenden Potentiale VSS (entsprechend Masse) oder VDD zu verwenden. Die Source des ersten Transistors T1 ist mit der einen Bitleitungshälfte BLH verbunden; die Source des zweiten Transistors T2 ist mit der anderen Bitleitungshälfte BLH verbunden. Zwei erste Betriebsarten-Auswahlsignale 01,02 sind mit den Gates des ersten bzw. zweiten Transistors T1,T2 verbunden.

Die somit mögliche Inversion der Daten A stellt die zweite Betriebsart MOD2 dar. Die Inversion der Daten A erfolgt in Betrieb folgendermaßen: Zunächst wird, wie bei jedem Halbleiterspeicher nach dem Stande der Technik üblich, ein Datum A aus einer Speicherzelle MC ausgelesen, über die der Speicherzelle MC zugeordnete Bitleitungshälfte (im Beispiel sei die eine Bitleitungshälfte BLH angenommen) auf die Bewerterschaltung AMPL gegeben und dort bewertet und verstärkt. Das Datum A liegt auch an der Source des ersten Transistors T1 an. Nun wird das mit dem ersten Transistor T1 verbundene eine (01) der beiden ersten Betriebsarten-Auswahlsignale 01,02 aktiviert. Das Datum A gelangt auf den Ladekondensator C und lädt bzw. entlädt diesen, je nach Wert des Datums A (log. "1 ", log. "0"). Anschließend werden das eine erste Betriebsarten-Auswahlsignal 01 deaktiviert und das andere erste Betriebsarten-Auswahlsignal 02 aktiviert. Infolgedessen sperrt der eine Transistor T1; der andere Transistor T2 leitet. Die auf dem Ladekondensator C gespeicherte Ladung gelangt dadurch über die andere Bitleitungshälfte (im Beispiel: BLH) an die Bewerterschaltung AMPL. Die Bewerterschaltung AMPL wird nun nochmals aktiviert, so daß sie das anliegende Datum bewertet. Da das Datum A bei dieser erneuten Bewertung jedoch an der anderen Bitleitungshälfte BLH anliegt (verglichen mit der ursprünglichen Bewertung), kippt die Bewerterschaltung AMPL in ihren komplementären Zustand, wodurch an der ursprünglichen einen Bitleitungshälfte BLH jetzt ein zum ursprünglich ausgelesenen bewerteten Datum A invertiertes Datum Ä anliegt. Dieses kann nun über die üblichen Speichereinrichtungen aus der Halbleiterschaltung ausgelesen werden und/oder in eine beliebige Speicherzelle MG an derselben Bitleitungshälfte BLH eingeschrieben werden. In Speicherzellen MC, die an der anderen Bitleitungshälfte BLH liegen, kann das ursprüngliche Datum A eingeschrieben werden.

Liegt das ausgelesene, bewertete Datum A vor der Dateninversion jedoch an der anderen Bitleitungshälfte BLH an (dies wird bekanntlich üblicherweise durch ein bestimmtes, frei wählbares Bit der Wortleitungsadresse entschieden), so kann entsprechend die Funktion der beiden ersten Betriebsarten-Auswahlsignale 01,02miteinander vertauscht werden (gesteuert ggf. ebenfalls durch das obengenannte Bit der Wortleitungsadresse). Das Vertauschen ist jedoch nicht notwendig, da an den beiden Bitleitungshälften BLH,BLH (bei intakten Speichern) nach erfolgter Bewertung stets zueinander komplementäre Daten anliegen: In diesem Fall wird bei Durchführung der zweiten Betriebsart MOD2, genau genommen, an der einen Bitleitungshälfte BLH nicht das ursprünglich (auf die andere Bitleitungshälfte BLH) ausgelesene, bewertete Datum A invertiert, sondern das dazu komplementäre Datum Ä. Dies ist jedoch ohne Belang, weil anschließend an das Aktivieren der Betriebsarten- Auswahlsignale 01,02 durch das erneute Bewerten in der Bewerterschaltung AMPL an der zweiten Bitleitungshälfte BLH ein zum ursprünglich ausgelesenen Datum A komplementäres Datum Ä entsteht.

Bekanntlich werden bei einem integrierten Halbleiterspeicher durch das Adressieren einer einzigen Speicherzelle MC über eine adressierte Wortleitung WL und eine Bitleitungsadresse die in allen Speicherzellen MC an der adressierten Wortleitung WL gespeicherten Daten Ai über die Bitleitungen BLi parallel ausgelesen und mittels aller Bewerterschaltungen AMPL bewertet und verstärkt. Die Auswahl eines bestimmten Datums A aus der Menge der Daten Ai mittels einer Bitleitungsadresse erfolgt anschließend; dabei wird dasjenige Datum A, das an der adressierten Bitleitung BL liegt und das bewertet und verstärkt wurde, auf eine externe Bitleitung ausgegeben. Aufgrund dieser Gegebenheiten läuft demzufolge auch die beschriebene zweite Betriebsart MOD2 parallel für den gesamten Block logischer Einheiten LU ab. Die zweite Betriebsart MOD2 ermöglicht also ein gleichzeitiges Invertieren von Daten Ai aller Speicherzellen MC einer Wortleitung WL.

In der Ausführungsform nach FIG 4 enthält der Block von logischen Einheiten LU weiterhin eine gemeinsame Leitung L, die, wie allgemein üblich bei längeren Leitungen, eine gewisse Eigenkapazität aufweist (in FIG 4 nicht dargestellt). Die gemeinsame Leitung L ist also, ähnlich einem Kondensator, auf ein festes Potential, z.B. auf das Potential VDD oder VSS, vorladbar. Sie ist außerdem mit einer Diskriminatorschaltung DISC verbunden. Die Diskriminatorschaltung DISC dient der Erkennung des Ladezustandes der gemeinsamen Leitung L.

In einer weiteren Ausführung der Erfindung, dargestellt in FIG 4, ist die gemeinsame Leitung L mit einer Stützkapazität CL verbunden. Die Stützkapazität CL ist ihrerseits wiederum mit einem der festen Potentiale VDD;VSS verbunden. Die Stützkapazität CL hat in Betrieb eine unterstützende Wirkung hinsichtlich der Vorladbarkeit der gemeinsamen Leitung L, da sie die Wirkung der genannten Eigenkapazität fördert.

Die gemeinsame Leitung L ist in jeder logischen Einheit LU über den stromführenden Pfad (= Kanal bei MOS-Transistoren) eines dritten Transistors T3 mit dem ersten Anschluß des Ladekondensators C verbunden. Die dritten Transistoren T3 sind durch ein zweites Betriebsarten-Auswahlsignal 03 gesteuert, so daß sie schaltbar sind. Diese Anordnung ermöglicht den Vergleich von i Daten miteinander (i = Anzahl der logischen Einheiten LU) im Sinne einer logischen Verknüpfung als eine dritte Betriebsart MOD3 der erfindungsgemäßen integrierten Halbleiterschaltung.

Die dritte Betriebsart MOD3 ermöglicht als logische Verknüpfung je nach schaltungstechnischer Auslegung des Blockes logischer Einheiten LU (dritte Transistoren T3: p- oder n-Kanal-Transistoren; zweites Betriebsarten-Auswahlsignal 03 in Abhängigkeit vom Kanaltyp der dritten Transistoren T3 "positive-going" oder "negative-going"; gemeinsame Leitung L vorladen auf Versorgungspotential VDD oder Masse VSS der integrierten Halbleiterschaltung; Dimensionierung der Diskriminatorschaltung DISC) folgende Boole'sche Operationen: AND, OR, NAND, NOR. Hinsichtlich weiterer Informationen über die Arbeitsweise und nähere Ausgestaltung der Diskriminatorschaltung DISC sowie einer möglichen Vorladeeinrichtung für die gemeinsame Leitung L wird auf die anmeldereigene ältere, nicht vorveröffentlichte Internationale Anmeldung WO 88/07292 verwiesen.

Im folgenden wird die Betriebsweise kurz erläutert: Zunächst werden durch Aktivieren einer ausgewählten Wortleitung WL die in allen an die Wortleitung WL angeschlossenen Speicherzellen MC gespeicherten Daten Ai über die jeweils zugehörige Bitleitung BL gelesen und mittels den zugeordneten Bewerterschaltungen AMPL bewertet und verstärkt. Danach weisen alle Bitleitungen BLi an je einer ihrer Bitleitungshälften BLH,i3CH - (beipielsweise an den einen Bitleitungshälften BLH) dasjenige logische Datum A auf, das über die jeweilige Bitleitung BL aus der der Wortleitung WL zugeordneten Speicherzelle MC ausgelesen worden ist. Durch Aktivieren desjenigen ersten Betriebsarten-Auswahlsignales 01,02 (im Beispiel 01) gelangen die Daten Ai parallel über den dem aktivierten ersten Betriebsarten-Auswahlsignal (01 angenommen) zugeordneten Transistor (z.B. T1) auf die ersten Anschlüsse der Ladekondensatoren C und laden bzw. entladen diese je nach Wert des betreffenden Datums A (log. 1 bzw. log. 0), wobei vorteilhafterweise das aktivierte eine erste Betriebsarten-Auswahlsignal (01 war angenommen) aktiviert bleibt, um die Bewerterschaltungen AMPL elektrisch leitend mit den Ladekondensatoren C verbunden zu halten. Es ist jedoch auch möglich, das eine erste Betriebsarten-Auswahlsignal 01 zu deaktivieren.

Die gemeinsame Leitung L ist spätestens jetzt auf eines der festen Potentiale VDD,VSS vorzuladen. Bei Verwendung der Stützkapazität CL ist diese mit einem der festen Potentiale VDD, VSS verbunden.

Nachstehend sind einige nach diesem Verfahren mittels der vorliegenden Anordnung möglichen logischen Vergleiche beschrieben: AND-Vergleich: Die gemeinsame Leitung L sei auf das feste Potential VDD vorgeladen (VDD entspreche beispielsweise wertemäßig dem Pegel eines Datums "log. 1 "). Nun wird das zweite Betriebsarten-Auswahlsignal03 aktiviert. Wurde zuvor an allen Ladekondensatoren C ein Datum A mit dem Wert "log. 1 " gespeichert, was wertemäßig gleich dem Wert des festen Potentials VDD sei, so sind alle dritten Transistoren T3 gesperrt (n-Kanal-Transistoren seien angenommen); die gemeinsame Leitung L bleibt vorgeladen. Dies erkennt die Diskrininatorschaltung DISC; sie gibt an ihrem Ausgang 0 ein entsprechendes Signal ab, das in diesem Fall anzeigt, daß das Ergebnis der logischen Verknüpfung "AND" gleich "log. 1 " ist.

Wurde jedoch an wenigstens einem der Ladekondensatoren C eine logische 0 als Datum A gespeichert, was wertemäßig gleich dem Wert des festen Potentials VSS sei, so leitet der diesem wenigstens einen Ladekondensator C zugeordnete dritte Transistor T3, was zu einem Absinken des Potentials der gemeinsamen Leitung L führt. Dies wiederum erkennt die Diskriminatorschaltung DISC; sie gibt an ihrem Ausgang 0 ein zum obengenannten Signal komplementäres Signal ab, das anzeigt, daß das Ergebnis der logischen Verknüpfung "AND" gleich "log. 0" ist.

Je nach Wahl des Pegels des Ausgangssignales 0 der Diskriminatorschaltung DISC für den Fall des Vorliegens einer log. 1 an allen Ladekondensatoren C lassen sich somit sowohl ein AND- wie auch ein NAND-Vergleich realisieren.

Wird die gemeinsame Leitung L auf den Wert des festen Potentials VSS (= Masse) vorgeladen, so lassen sich je nach Wahl des Wertes des Signales am Ausgang 0 der Diskriminatorschaltung DISC für den Fall, in dem alle an den Ladekondensatoren C gespeicherten Daten gleich log. 0 sind, die Funktionen OR bzw. NOR als dritte Betriebsart MOD3 (d.h. logischer Vergleich) erzielen. Der Fachmann kann dies leicht nachvollziehen anhand der obigen Ausführungen zu AND-/NAND-Vergleichen. Es ist auch günstig, zum Aktivieren des zweiten Betriebsarten-Auswahlsignales 03 einen Pegel vorzusehen, der wertemäßig zwischen den festen Potentialen VSS und VDD liegt. Im übrigen wird in diesem Zusammenhang nochmals auf die anmeldereigene ältere, nicht vorveröffentlichte Internationale Anmeldung WO 88/07292 hingewiesen, deren Offenbarung, soweit relevant, Bestandteil der vorliegenden Beschreibung ist. Insbesondere ist in der genannten Anmeldung auch eine Anordnung offenbart, die es ermöglicht, in Betrieb wahlweise die logischen Vergleiche AND,NAND,OR,NOR durchzuführen.

Soll mit der Anordnung nach FIG 4 jedoch die zweite Betriebsart MOD2 durchgeführt werden, so sind die dritten Transistoren T3 ständig gesperrt zu halten, d.h. das zweite Betriebsarten-Auswahlsignal 03 ist stets inaktiv zu halten.

Eine weitere vorteilhafte Ausführungsform der Erfindung ist in FIG 5 dargestellt. FIG 5 zeigt außer den bereits beschriebenen Merkmalen noch folgende Merkmale je logischer Einheit LU:
Zwischen den Drains der ersten beiden Transistoren T1,T2, die der Dateninversion dienen, und jeder der beiden Bitleitungshälften BLH;BLH einer Bitleitung BL sind je ein erster Transfertransistor TT1;TT11 und ein zweiter Transfertransistor TT2;TT12 mit ihren stromführenden Pfaden (bei MOS-Transistoren: = Kanälen) in Serie hintereinander angeordnet. Die Gates der beiden zweiten Transfertransistoren TT2;TT12 sind jeweils mit einem von zwei dritten Betriebsarten-Auswahlsignalen 04;05 verbunden. Das Gate des einen ersten Transfertransistors TT1 ist mit der anderen Bitleitungshälfte BLH verbunden. Das Gate des anderen ersten Transfertransistors TT11 ist mit der einen Bitleitungshälfte BLH verbunden.

Diese Ausführungsform ermöglicht ein ein- bis mehrmaliges Ausführen der Boole'schen Operationen XNOR,OR und NAND je Bitleitung BL als vierte Betriebsart MOD4. Bei einer einmaligen Ausführung wird ein einzelnes aus einer Speicherzelle MG ausgelesenes, bewertetes Datum A mit einem an die betreffende logische Einheit LU anzulegenden Vergleichsdatum X mittels der gewünschten Boo- le'schen Operation verglichen. Es werden also zwei Bits miteinander verglichen. Bei einer mehrmaligen Ausführung werden mehrere nacheinandere aus mehreren Speicherzellen MC entlang einer einzigen Bitleitung BL ausgelesene, bewertete Daten Ap (p = Anzahl der Daten) mit mehreren nacheinander an die betreffende logische Einheit LU anzulegenden Vergleichsdaten Xp mittels der gewünschten Boole'schen Operationen verglichen (wortweiser Vergleich).

Im einzelnen hat die vierte Betriebsart MOD4 folgenden Verlauf: Zu Beginn werden die Ladekondensatoren C aller logischen Einheiten LU auf das feste Potential VDD aufgeladen (dessen Wert entspreche wiederum dem Wert des Pegels log. 1). Das Aufladen kann entweder über die gemeinsame Leitung L und die dazugehörigen dritten Transistoren T3 erfolgen oder über die Bitleitungen BL. In letzterem Fall werden die Bewerterschaltungen AMPL in einen beliebigen Bewertungszustand gebracht, wodurch jeweils an einer der Bitleitungshälften BLH,BLH eine log. 1 liegt. Die Mittel dazu sind dem Fachmann geläufig. Je logischer Einheit LU wird nun derjenige der beiden ersten Transistoren T1,T2, der mit derjenigen Bitleitungshälfte BLH,BLH verbunden ist, an der die log. 1 anliegt, mittels des ihm zugeordneten einen bzw. anderen der beiden ersten Betriebsarten-Auswahlsignale 01;02 leitend geschaltet. Somit gelangt die log. 1 als festes Potential VDD auf jeden Ladekondensator C; diese sind vorgeladen. Anschließend bleiben beide ersten Betriebsarten-Auswahlsignale 01,02, ebenso wie das zweite Betriebsarten-Auswahlsignal 03, deaktiviert.

Für die nachfolgenden Vorgänge wird eine einzige Bitleitung BL mit der daran angeschlossenen logischen Einheit LU betrachtet; die entsprechenden Vorgänge an den restlichen Bitleitungen BL und logischen Einheiten LU bleiben unberücksichtigt.

In bekannter Weise wird jetzt ein Datum A, das in einer mit der Bitleitung BL verbundenen, durch eine Wortleitung WL adressierten Speicherzelle MC gespeichert ist; ausgelesen und mittels der Bewerterschaltung AMPL bewertet und verstärkt. Nachfolgend sei angenommen, daß das Datum A auf der einen Bitleitungshälfte BLH anliege. Somit liegt an der anderen Bitleitungshälfte BLH ein zum Datum A komplementäres Datum Ä an. Nun nehmen das eine dritte Betriebsarten-Auswahlsignal 04 den Wert des Vergleichsdatums X an und das andere dritte Betriebsarten-Auswahlsignal 05 den Wert eines zum Vergleichsdatum X komplementären Vergleichsdatums X an.

Sind das ausgelesene, bewertete Datum A und das Vergleichsdatum X gleich, so sind entweder der eine erste Transfertransistor TT1 und der andere zweite Transfertransistor TT12 gesperrt (Datum A = Vergleichsdatum X = log. 1) oder der andere erste Transfertransistor TT11 und der eine zweite Transfertransistor TT2 gesperrt (Datum A = Vergleichsdatum X = log. 0). In beiden Fällen bleibt somit die auf dem Ladekondensator C gespeicherte logische 1 (= festes Potential VDD) erhalten. Am Ladekondensator C liegt also das Ergebnis der Boole'schen Operation "Datum A XNOR Vergleichsdatum X" = "log. 1 XNOR log. 1 " bzw. "log. 0 XNOR log. 0" = "log. 1 " an.

Sind jedoch das ausgelesene, bewertete Datum A und das Vergleichsdatum X ungleich, so sind entweder sowohl der eine erste Transfertransistor TT1 und der eine zweite Transfertransistor TT2 (Datum A = log. 0; Vergleichsdatum X = log. 1) oder der andere erste Transfertransistor TT11 und der andere zweite Transfertransistor TT12 (Datum A = log. 1; Vergleichsdatum X = log. 0) leitend. In jedem dieser beiden Fälle wird diejenige Bitleitungshälfte BLH,BLH, die den Zustand log. 0 (= festes Potential VSS = Masse) aufweist (weil entweder Datum A = log. 0 oder komplementäres Datum Ä = log. 0), über die genannten leitenden Transfertransistoren mit der ersten Elektrode des Ladekondensators C verbunden; dieser wird somit entladen auf das feste Potential VSS = Masse.

Auf diese Weise wurde ein gespeichertes Bit (Datum A) mit einem Vergleichsbit X verglichen.

Wiederholt man die vorgenannten Schritte (mit Ausnahme des Schrittes "Vorladen des Ladekondensators C auf das feste Potential VDD") mehrmals hintereinander, so lassen sich mehrere (in verschiedenen Speicherzellen MC entlang der einen Bitleitung BL gespeicherte) Daten Ap (zeitlich hintereinander) mit mehreren Daten Xp vergleichen (z.B. Boole'sche Operation XNOR); das Endergebnis ist durch den Endzustand des Ladekondensators C bestimmt (der zwischendurch nie mehr auf das feste Potential VDD geladen wird). Dieses Endergebnis ist über einen der beiden ersten Transistoren T1,T2 und das entsprechende erste Betriebsarten-Auswahlsignal 01,02 an die Bewerterschaltung AMPL anlegbar und durch diese bewertbar, so daß es an der Bewerterschaltung AMPL stabil zur Verfügung steht und beispielsweise über einen Datenausgang des Speicherbereiches MEM auslesbar ist. Auf diese Weise läßt sich sehr schnell innerhalb der integrierten Halbleiterschaltung beispielsweise ein in Speicherzellen MC entlang einer Bitleitung BL gespeichertes Wort (Daten Ap) mit einem in Wortform vorliegenden Suchbegriff (Vergleichsdaten Xp) vergleichen. Der Vergleich selbst erfolgt für alle Bitleitungen BL zeitgleich parallel. Die Ergebnisse an jeder einzelnen Bitleitung BL sind hintereinander von den einzelnen Bewerterschaltungen AMPL beispielsweise über den obengenannten Datenausgang durch Anlegen der einzelnen Bitleitungsadressen auslesbar.

Es lassen sich mit der vorliegenden Ausgestaltung jedoch auch die logischen Operationen OR und NAND durchführen:

### a) OR-Operation:

Die vierte Betrlebsart MOD4 wird ausgeführt wie zuvor anhand der XNOR-Operation beschrieben mit folgender Ausnahme: Bei Anliegen des Datums A auf der einen Bitleitungshälfte BLH wird das eine dritte Betriebsarten-Auswahlsignal 04 mit einem Datum X verbunden, das zum Vergleichsdatum X komplementär ist; das andere dritte Betriebsarten-Auswahlsignal 05 ist stets deaktiviert. Weist das Vergleichsdatum X den Wert log. 1 auf, so sind beide zweite Transfertransistoren TT2,TT12 stets gesperrt; am Ladekondensator C bleibt die Vorladung erhalten, was als Ergebnis bedeutet: log. 1. Weist das Vergleichsdatum X hingegen den Wert log. 0 auf, so ist der eine zweite Transfertransistor TT2 stets leitend wegen des Datums X. Der eine erste Transfertransistor TT1 ist dagegen genau dann leitend, wenn das Datum A den Wert log. 0 aufweist; in diesem Fall wird der Ladekondensator C auf log.0 = festes Potential VSS entladen. Ansonsten ist der eine erste Transfertransistor TT1 gesperrt, wodurch der Ladekondensator C geladen bleibt.

### b) NAND-Operation:

Im Gegensatz zur OR-Operation ist das eine dritte Betriebsarten-Auswahlsignal 04 stets deaktiviert, während am anderen dritten Betriebsarten-Auswahlsignal 05 das Vergleichsdatum X liegt. Der Ladekondensator C wird nur in dem Fall auf log. 0 entladen, wenn sowohl das Datum A (bei dem wiederum angenommen sei, daß es an der einen Bitleitungshälfte BLH anliege) wie auch das Datum X gleich log. 1 sind. Ansonsten sind immer wenigstens einer der ersten und einer der zweiten Transfertransistoren TT1,TT11, TT2,TT12 gesperrt.

FIG 6 zeigt eine weitere vorteilhafte Ausgestaltung der Erfindung. Sie unterscheidet sich von der Ausgestaltung nach FIG 5 durch folgende Merkmale:
Die Gates der beiden ersten Transfertransistoren TT1,TT11 sind zusätzlich mit den ersten Elektroden zweier zwischenspeichernder Kapazitäten C1,C11 unter Bildung zweier Speicherknoten S1,S11 verbunden. Die zweiten Elektroden der beiden zwischenspeichernden Kapazitäten C1,C11 sind mit einem der beiden festen Potentiale VSS,VDD verbunden. Weiterhin sind zwischen den beiden Speicherknoten S1;S11 und den entsprechenden Bitleitungshälften BLH;BLH Speichertransistoren ST1;ST11 mit ihren Kanälen angeordnet. Deren Gates sind mit einem vierten Betriebsarten-Auswahlsignal 06 verbunden.

Diese Ausgestaltung ermöglicht das Betreiben der erfindungsgemäßen integrierten Halbleiterschaltung in einer fünften Betriebsart MOD5. In der fünften Betriebsart MOD5 sind verschiedene Operationen möglich, beispielsweise die Boole'schen Operationen AND,NAND,OR,NOR,XOR,XNOR. Dazu wird, jeweils parallel für den gesamten Block logischer Einheiten LU, an jede Bitleitungshälfte BLH (bzw. BLH) ein Vergleichsdatum X angelegt (beispielsweise, wie bereits beschrieben, an alle Bitleitungshälften BLH dasselbe Vergleichsdatum X über die gemeinsame Leitung L und dem einen ersten Transistor T1, oder über den Dateneingang des Halbleiterspeichers und die einzelnen Bewerterschaltungen AMPL; in letzterem Fall ist es möglich, an die verschiedenen Bitleitungshälften BLH verschiedene logische Werte des Vergleichsdatums X anzulegen). Die an den einzelnen Bitleitungshälften BLH anliegenden Vergleichsdaten X (bzw. Xi bei verschiedenen Vergleichsdaten) werden nun über die Bewerterschaltungen AMPL bewertet, so daß sich an den jeweils anderen Bitleitungshälften BLH ein zum Vergleichsdatum X komplementäres Datum X ausbildet (bekannte FlipFlop-Funktion der Bewerterschaltungen AMPL). Anschließend wird das vierte Betriebsarten-Auswahlsignal 06 aktiviert, so daß je Bitleitung BL das auf den Bitleitungshälften BLH,BLH anliegende Vergleichsdatum X bzw. das dazu komplementäre Datum X an die erste Elektrode des zugehörigen Speicherknotens S1;S11 gelangt und dort gespeichert wird. Danach wird das vierte Betriebsarten-Auswahlsignal 06 wieder deaktiviert.

Alternativ zu dieser Art, die Speicherknoten S1,S11 vorzuladen, ist es auch möglich, die Vergleichsdaten Xi parallel für alle Bitleitungen BL aus dem Speicherzellenfeld MCF her auszulesen. Dazu wird, wie üblich, eine bestimmte Wortleitung WL adressiert, so daß die in allen mit der Wortleitung WL verbundenen Speicherzellen MC gespeicherten Daten parallel zueinander auf die Bitleitungen BL gelangen und durch die Bewerterschaltungen AMPL bewertet und verstärkt werden. Das Abspeichern in den Speicherknoten S1,S11 erfolgt dann mittels des vierten Betriebsarten-Auswahlsignals 06, wie bereits beschrieben.

Nun werden die Ladekondensatoren C des Blockes logischer Einheiten LU auf das feste Potential VDD bzw. VSS vorgeladen, wie bei den zuvor beschriebenen Betriebsarten MODk bereits erläutert. Ab jetzt sind die eigentlichen logischen Operationen durchführbar.

Dies kann auf zwei verschiedene Arten erfolgen:
a) Bitleitungs-orientiert und
b) wortleitungs-orientiert.
a) Zunächst sei die bitleitungs-orientierte Art erläutert:

Die konkrete Aufgabenstellung dazu laute beispielsweise: Auf jedes in Speicherzellen MC an (ein und derselben) Bitleitung BL gespeicherte Datum A ist die Boole'sche Operation NAND mittels eines Vergleichsdatums X anzuwenden, wobei das Vergleichsdatum X für jedes Datum A einen anderen Wert aufweisen kann (d.h. eine Folge von Daten Ap (p = Anzahl der Wortleitungen WL) wird mit einem Datenwort Xp verglichen, das p verschiedene Vergleichsdaten X enthält).

Werden die Daten A über die eine Bitleitungshälfte BLH ausgelesen, so sind zur Durchführung der NAND-Operation das eine dritte Betriebsarten-Auswahlsignal 04 auf log. 0 konstant zu setzen und das andere dritte Betriebsarten-Auswahlsignal 05 auf log. 1. Werden die Daten A jedoch über die andere Bitleitungshälfte BLH ausgelesen, so sind zur Durchführung der NAND-Operation das eine dritte Betriebsarten-Auswahlsignal 04 auf log. 1 konstant zu setzen und das andere dritte Betriebsarten-Auswahlsignal 05 auf log. 0. Die eigentliche Boole'sche Operation wird nun analog ausgeführt wie hinsichtlich der vierten Betriebsart MOD4 zuvor bereits beschrieben mit folgenden wesentlichen Unterschieden:
1.) Die dritten Betriebsarten-Auswahlsignale 04,05 weisen ihre oben angegebenen Werte log. 0 bzw. log. 1 konstant auf; sie wirken als echte Steuersignale und nicht als Vergleichsdatum X bzw. dazu komplementäres Datum X, wie in der vierten Betriebsart MOD4. Infolgedessen sind der eine zweite Transfertransistor TT2 stets gesperrt und der andere zweite Transfertransistor TT12 stets leitend. 2.) Ist der logische Vergleich so auszuführen, daß jedes auszulesende Datum A mit einem (anderen) Wert des Vergleichsdatums X (im Sinne des obengenannten Datenwortes Xp) zu vergleichen ist, so ist das entsprechende Vergleichsdatum X des Datenwortes Xp auf den Speicherknoten S1 (bzw. S11) abzuspeichern, bevor das entsprechende Datum A ausgelesen und bewertet wird. Sind die verschiedenen Daten Ap jedoch jeweils mit ein und demselben Vergleichsdatum X zu vergleichen, so braucht letzteres nur einmal (d.h. vor Beginn des Auslesevorganges für das erste Datum A) abgespeichert zu werden.

Nähere Erläuterungen sind für den Fachmann anhand der Parallelen zur bereits beschriebenen vierten Betriebsart MOD4 nicht nötig. Es wird jedoch darauf hingewiesen, daß die Ladezustände der einzelnen Ladekondensatoren C (d.h. also, das Ergebnis der logischen Operationen) über die der jeweiligen logischen Einheit LU zugeordnete Bitleitung BL in Speicherzellen MC des Speicherzellenfeldes MCF abspeicherbar sind.

Ein Ausführen der Boole'schen Operation AND erfolgt in der Weise, daß zunächst die Boole'sche Operation NAND ausgeführt wird und deren Endergebnis (d.h. der Ladezustand am ersten Anschluß des Ladekondensators C) mittels der bereits beschriebenen zweiten Betriebsart MOD2 invertiert wird.

Zur Durchführung der Boole'schen Operation OR werden die an die dritten Betriebsarten- Auswahlsignale 04,05 gegenüber der zuvor beschriebenen NAND-Operation vertauscht (d.h. also im Beispiel, daß das eine dritte Betriebsarten-Auswahlsignal 04 konstant log. 1 aufweist und das andere dritte Betriebsarten-Auswahlsignal 05 konstant log. 0).

Die NOR-Operation wird, analog zur bereits beschriebenen AND-Operation, ausgeführt, indem zunächst die OR-Operation als fünfte Betriebsart MOD5 ausgeführt wird und anschließend daran die zweite Betriebsart MOD2 (Invertieren).

Entsprechendes gilt für die XOR-Operation: Dazu sind beide dritten Betriebsarten-Auswahlsignale 04,05 auf log. 1 zu halten; die XNOR-Funktion wird durch Anwenden der zweiten Betriebsart MOD2 nach Ausführen der fünften Betriebsart MOD5 erzielt.

### b) Nunmehr sei die wortleitungsorientierte Art der fünften Betriebsart MOD5 erläutert:

Die konkrete Aufgabenstellung hierzu laute beispielsweise: Auf jedes in Speicherzellen MC an (ein und derselben) Wortleitung WL gespeicherte Datum A ist die Boole'sche Operation NAND mittels eines Vergleichsdatums X anzuwenden, wobei an jeder logischen Einheit LU ein anderes Vergleichsdatum X (gleichzeitig) anliegen kann (d.h. also, am gesamten Block logischer Einheiten LU liegt ein komplettes Vergleichswort Xi mit i = Gesamtzahl der Anzahl logischer Einheiten LU). Die einzelnen Vergleichsdaten X werden zunächst in bereits beschriebener Weise in den Speicherknoten S1,S11 abgespeichert. Dann werden, falls noch nicht erfolgt, die Ladekondensatoren C der logischen Einheiten LU auf das feste Potential VDD bzw. VSS vorgeladen.

Jetzt wird eine bestimmte Wortleitung WL adressiert, die in den damit verbundenen Speicherzellen MC gespeicherten Daten A werden auf die Bitleitungen BL ausgelesen und durch die Bewerterschaltungen AMPL bewertet und verstärkt. Die dritten Betriebsarten-Auswahlsignale 04,05 nehmen nun die unter Punkt a) der fünften Betriebsart MOD5 bereits beschriebenen Werte an (NAND/AND-Operation: 04 = log. 0, 05 = log. 1; OR/NOR-Operation: 04 = log. 1, 05 = log. 0; XOR/XNOR-Operation: 04 = 05 = log. 1; jeweils bei Auslesen des Datums A auf die eine Bitleitungshälfte BLH).

Dadurch werden bei jeder logischen Einheit LU das auf der jeweiligen Bitleitungshälfte BLH anliegende Datum A mit dem in dem jeweiligen Speicherknoten S1 gespeicherten Vergleichsdatum X (bzw. das auf der anderen Bitleitungshälfte BLH liegende komplementäre Datum Ä mit dem im jeweiligen Speicherknoten S11 gespeicherten komplementären Datum X) entsprechend den angelegten dritten Betriebsarten-Auswahlsignalen 04,05 verglichen. Das bei jeder einzelnen logischen Einheit LU aus dem Vergleich resultierende Ergebnis der Boole'schen Operation (im gewählten Beispiel: NAND-Operation) bestimmt, analog zu den bereits beschriebenen Betriebsarten, den Potentialzustand des jeweiligen Ladekondensators C. Dieses Ergebnis ist wiederum, wie ebenfalls bereits beschrieben, invertierbar (zweite Betriebsart MOD2), über die Bewerterschaltungen AMPL und den Datenausgang des Halbleiterspeichers auslesbar sowie im Speicherzellenfeld MCF abspeicherbar. Außerdem ist auf die Ladekondensatoren C des gesamten Blokkes logischer Einheiten LU parallel die dritte Betriebsart MOD3 anwendbar.

Die Ausführungsform nach FIG 7 unterscheidet sich von der nach FIG 6 dadurch, daß sie anstelle eines einzigen vierten Betriebsarten-Auswahlsignales 06 zwei voneinander unabhängig ansteuerbare vierte Betriebsarten-Auswahlsignale 06,07 aufweist. Das eine vierte Betriebsarten-Auswahlsignal 06 ist bei jeder logischen Einheit LU mit dem Gate des einen Speichertransistors ST1 verbunden. Das andere vierte Betriebsarten-Auswahlsignal 07 ist dagegen bei jeder logischen Einheit LU mit dem Gate des anderen Speichertransistors ST11 verbunden. Mit dieser Ausführungsform ist die zuvor beschriebene fünfte Betriebsart MOD5 möglich mit ihren einzelnen verschiedenen Operationen unter Verwendung von "Maskierbits": Soll eine (oder mehrere) bestimmte logische Einheit LU aus dem Block logischer Einheiten LU zur Durchführung der fünften Betriebsart MOD5 nicht verwendet werden (d.h. z.B., daß der Ladezustand ihres Ladekondensators C unabhängig von irgendwelchen Daten unverändert erhalten bleiben soll), so ist in beiden Speicherknoten S1,S11 der logischen Einheit LU ein Wert abzuspeichern, der beide erste Transfertransistoren TT1, TT11 sicher sperrt (im Falle von n-Kanal-Transistoren also "log. 0"). Damit kann der Ladekondensator C nicht entladen werden.

Die beiden Bitleitungshälften BLH,BLH, über die das Vergleichsdatum X (und das dazu komplementäre Datum X) in die Speicherknoten S1,S11 geladen wird, weisen bekanntlich stets zueinander komplementäre elektrische Zustände auf. Durch Aktivieren des vierten Betriebsarten-Auswahlsignales 06 in FIG 6 können also nicht beide Speicherknoten S1,S11 gleichzeitig denjenigen gleichen Wert abspeichern, der beide erste Transfertransistoren TT1,TT11 sperrt. Durch Verwendung zweier verschiedener, voneinander unabhängiger Betriebsarten-Auswahlsignale 06,07ist dies jedoch erreichbar: Unter der Annahme, daß der abzuspeichernde Wert "log. 0" beide ersten Transfertransistoren TT1, TT11 sperrt, wird folgendermaßen verfahren:
Zunächst wird die eine Bitleitungshälfte BLH (mit bekannten, bereits beschriebenen Maßnahmen) mit dem Wert "log. 0" belegt. Dann wird das eine vierte Betriebsarten-Auswahlsignal 06 aktiviert, so daß die angelegte "log. 0" an den einen Speicherknoten S1 gelangt. Durch anschließendes Deaktivieren des einen vierten Betriebsarten-Auswahlsignales 06 bleibt die "log. 0" auf dem einen Speicherknoten S1 gespeichert, der damit verbundene andere erste Transfertransistor TT11 bleibt sicher gesperrt.

Anschließend daran wird die andere Bitleitungshälfte BLH mit dem Wert "log. 0" belegt. Dann wird das andere vierte Betriebsarten-Auswahlsignal 07 aktiviert, so daß die angelegte "log. 0" an den anderen Speicherknoten S11 gelangt. Durch anschließendes Deaktivieren des anderen vierten Betriebsarten-Auswahlsignales 07 bleibt die "log. 0" auf dem anderen Speicherknoten S11 gespeichert, der damit verbundene eine erste Transfertransistor TT1 bleibt ebenfalls sicher gesperrt.

Sollen bei einer Ausgestaltung nach den FIG 6 oder 7 die Betriebsarten MOD3 oder MOD4 ausgeführt werden, so sind die vierten Betriebsarten- Auswahlsignale 06,07 konstant aktiviert zu halten. Auf eine Durchführung der zweiten Betriebsart MOD2 ist der Zustand der vierten Betriebsarten- Auswahlsignale 06,07 ohne Einfluß, weil die dritten Betriebsarten-Auswahlsignale 04,05deaktiviert sind. Zur Durchführung der ersten Betriebsart MOD1 sind, wie bereits beschrieben, alle Betriebsarten- Auswahlsignale 0j inaktiv zu halten.

Die FIG 8 und 9 zeigen weitere mögliche Ausgestaltungen der Erfindung. Sie ermöglichen Addition und Subtraktion von Daten Ai, die in Speicherzellen MC entlang einer Wortleitung WL gespeichert sind und aus dieser (parallel) ausgelesen und bewertet werden, mit bzw. von Vergleichsdaten Xi, die in den Speicherknoten S1 gespeichert sind. Sie ermöglichen weiterhin Multiplikation und Division, da diese bekanntlich lediglich ein mehrmaliges Ausführen von Addition bzw. Subtraktion sind. Diese arithmetischen Operationen sind eine sechste Betriebsart MOD6 der erfindungsgemäßen Schaltung. Verglichen mit der Ausführungsform nach FIG 7 weisen die Schaltungen nach den FIG 8 und 9 zusätzlich jeweils einen Schiebetransistor TS auf, der mit seinem stromführenden Pfad (= Kanal) zwischen dem ersten Anschluß des Ladekondensators C einer logischen Einheit LU und der in der Reihenfolge der einzelnen logischen Einheiten LU vorhergehenden (FIG 8) bzw. nachfolgenden (FIG 9) Bitleitung BL angeordnet ist. Ob die Anbindung an die eine (BLH) oder an die andere Bitleitungshälfte BLH erfolgt, ist für die ausführbaren Funktionen, prinzipiell gesehen, ohne Belang. Die Schiebetransistoren TS sind an ihren Gates gemeinsam mit einem Schiebesignal 0S verbunden, das als fünftes Betriebsarten-Auswahlsignal wirkt. Diese Anordnung ermöglicht eine Schieberegisterfunktion: Das an einem Ladekondensator C gespeicherte Potential ist damit an die entsprechende benachbarte Bitleitung BL weiterschiebbar und von dieser aus über einen der beiden Transistoren T1,T2 weiterschiebbar an den damit verbundenen Ladekondensator C.

Bei der Ausführungsform nach FIG 8 liegt das "most significant bit" des einen Operanden (beispielsweise der Daten Ai) an der in einer betrachteten Reihenfolge (von oben nach unten) der Bitleitungen BL ersten Bitleitung. Hingegen liegt bei der Ausführungsform nach FIG 9 das "most significant bit" an der in der betrachteten Reihenfolge letzten Bitleitung BL.

Prinzipiell läuft die Addition folgendermaßen ab: Zunächst wird der eine Operand (je logischer Einheit LU ein Vergleichsdatum X) in die einen Speicherknoten S1 (bzw. S11) der logischen Einheiten LU gespeichert. Dann wird der andere Operand (je Bitleitung als Datum A) parallel aus allen mit einer bestimmten, adressierten Wortleitung WL verbundenen Speicherzellen MC ausgelesen, bewertet und verstärkt. Beide Operanden werden nun, wie als vierte Betriebsart MOD4 bereits beschrieben, mittels der Boole'schen Operation XOR miteinander verknüpft (dies entspricht einer sog. "Halbaddition"); das Ergebnis ist durch den sich einstellenden Ladezustand jedes einzelnen Ladekondensators C gegeben. Dieses Ergebnis wird nun unter Adressierung einer anderen Wortleitung WL in das Speicherzellenfeld MCF zurückgeschrieben. Anschließend wird die ursprünglich adressierte Wortleitung WL nochmals adressiert, wodurch die dort gespeicherten Daten A (nochmals) an die Bitleitungen BL gelangen. Jetzt wird die Boole'sche Operation AND als vierte Betriebsart MOD4 ausgeführt für die Daten A und die (noch gespeicherten) Vergleichsdaten X. Damit ergibt sich je logischer Einheit LU der sog. Übertrag ("Carry-Bit") am Ladekondensator C. Durch Aktivieren des Schiebesignals 0S wird dieser Übertrag nun auf die benachbarte Bitleitung weitergeschoben, auf dieser mittels der Bewerterschaltung AMPL bewertet und verstärkt. Das Schiebesignal 0S wird wieder deaktiviert. Die so behandelten Überträge werden nun in den einen Speicherknoten S1 der jeweiligen logischen Einheit LU abgespeichert. Nun wird diejenige Wortleitung adressiert, mittels derer das Ergebnis der zuvor beschriebenen XOR-Operation abgespeichert wurde. Dieses wird wieder auf die Bitleitungen ausgelesen, bewertet, verstärkt und mittels der vierten Betriebsart MOD4 der Boole'schen Operation XOR hinsichtlich des in den Speicherknoten S1 gespeicherten Übertrages unterzogen. Deren Ergebnis ist dann das Gesamtergebnis der Addition.

Bei der Subtraktion wird zunächst die zweite Betriebsart MOD2 (Invertieren) ausgeführt und anschließend die sechste Betriebsart MOD6. Durch mehrmaliges Ausführen der Subtraktion ist auch eine Division möglich.

Besonders vorteilhaft ist es, wenn bei der in der Reihenfolge ersten logischen Einheit LU der erste Anschluß des Ladekondensators C über den Schiebetransistor TS mit der in der Reihenfolge letzten Bitleitung BL verbunden ist oder wenn bei der in der Reihenfolge letzten logischen Einheit LU der erste Anschluß des Ladekondensators C über den Schiebetransistor TS mit der in der Reihenfolge ersten Bitleitung verbunden ist. Mit diesen Ausführungsformen sind dann die sog. Modulo-Addition und Modulo-Subtraktion möglich.

Die zwischenspeichernden Kapazitäten C1,C11 müssen nicht unbedingt in Form separater Schaltelemente realisiert sein. Dazu ist es vorteilhaft, die parasitären Kapazitätseffekte der ersten Transfertransistoren TT1,TT11 (z.B. deren Gateoxid-Kapazitäten) auszunutzen.

Weiterhin ist es vorteilhaft, wenn die Ladekondensatoren C durch statische Speicherzellen ersetzt sind.

Die Speicherzellen MC des Speicherzellenfeldes MCF können vorteilhafterweise vom Typ "dynamische Random-Access-Zelle" sein oder vom Typ "statische Random-Access-Zelle" oder vom nichtflüchtigen Typ (wie z.B. EPROM,EEPROM).

Die erfindungsgemäße integrierte Halbleiterschaltung bietet weiterhin durch Kombination der beschriebenen verschiedenen Betriebsarten MODk die Möglichkeit, noch weitere, nicht beschriebene Operationen ausführen zu können.

## Patentansprüche (Patentansprüche für folgende(n) Vertragsstaat(en) : AT, IT, NL)

1. Integrierte Halbleiterschaltung mit einem Speicherbereich (MEM),
- der wenigstens ein Speicherzellenfeld (MCF) mit über Wortleitungen (WL) und Bitleitungen (BL) adressierbaren Speicherzellen (MC) enthält und
- der eine der Anzahl der Bitleitungen (BL) entsprechende Anzahl von Bewerterschaltungen (AMPL) enthält, wobei jede Bewerterschaltung (AMPL) so mit einer Bitleitung (BL) verbunden ist, daß sie diese in zwei wenigstens annähernd gleiche Bitleitungshälften (BLH,BLH) aufteilt,
gekennzeichnet durch folgende Merkmale:
- Die Halbleiterschaltung enthält weiterhin einen Block von logischen Einheiten (LU),
- jede logische Einheit (LU) ist mit einer Bitleitung (BL) über deren beide Bitleitungshälften (BLH,BLH) verbunden,
- die logischen Einheiten (LU) dienen einer digitalen Verarbeitung von aus dem Speicherbereich (MEM) über die Bitleitungen (BL) ausgelesenen, bewerteten Daten,
- der Block von logischen Einheiten (LU) ist in verschiedenen Betriebsarten (MODk, k = 1...n) betreibbar,
- die Betriebsarten (MODk) sind durch Betriebsartenauswahlsignale (0j, j = 1...m) wählbar.

2. Integrierte Halbleiterschaltung nach Anspruch 1, dadurch gekennzeichnet, daß in einer ersten Betriebsart (MOD1) alle Betriebsartenauswahlsignale (0j) deaktiviert sind, so daß die ausgelesenen, bewerteten Daten unverändert bleiben.

3. Integrierte Halbleiterschaltung nach Anspruch 1 oder 2, dadurch gekennzeichnet,
- daß jede logische Einheit (LU) wenigstens zwei einer Dateninversion der ausgelesenen, bewerteten Daten dienende Transistoren (T1,T2) und einen Ladekondensator (C) enthält,
- daß die Drains der der Dateninversion dienenden Transistoren (T1,T2) mit einem ersten Anschluß des Ladekondensators (C) verbunden sind, dessen zweiter Anschluß an ein festes Potential (VSS;VDD) angeschlossen ist,
- daß jede Source der Transistoren (T1,T2) mit einer der beiden Bitleitungshälften (BLH;BLH) verbunden ist,
- daß die Gates der Transistoren (T1,T2) mit zwei ersten Betriebsartenauswahl-Signalen (01,02) verbunden sind und
- daß die Dateninversion eine zweite Betriebsart (MOD2) ist (FIG 3).

4. Integrierte Halbleiterschaltung nach Anspruch 3, dadurch gekennzeichnet,
- daß die ersten Anschlüsse der Ladekondensatoren (C) über dritte Transistoren (T3) schaltbar mit einer gemeinsamen Leitung (L) verbunden sind, die auf eines der festen Potentiale (VDD;VSS) vorladbar ist,
- daß die gemeinsame Leitung (L) mit einer Diskriminatorschaltung (DISC) verbunden ist zur Erkennung des Ladezustandes der gemeinsamen Leitung (L),
- daß die dritten Transistoren (T3) durch ein zweites Betriebsartenauswahl-Signal (03) gesteuert sind zur Durchführung eines i-fachen logischen Vergleichs der ausgelesenen, bewerteten Daten mit i = Anzahl der logischen Einheiten (LU),
- daß der i-fache logische Vergleich eine dritte Betriebsart (MOD3) ist und
- daß das Ergebnis des i-fachen logischen Vergleiches am Ausgang der Diskriminatorschaltung (DISC) anliegt (FIG 4).

5. Integrierte Halbleiterschaltung nach Anspruch 4, dadurch gekennzeichnet, daß die gemeinsame Leitung (L) mit einer Stützkapazität (CL) verbunden ist, die ihrerseits wiederum mit einem der festen Potentiale (VDD;VSS) verbunden ist.

6. Integrierte Halbleiterschaltung nach Anspruch 3, 4 oder 5 , dadurch gekennzeichnet,
- daß zwischen den Drains der ersten beiden Transistoren (T1,T2) und den beiden Bitleitungshälften (BLH,BLH) je ein erster Transfertransistor (TT1,TT11) und ein zweiter Transfertransistor (TT2,TT12) mit ihren Kanälen in Serie hintereinander angeordnet sind,
- daß die Gates der beiden zweiten Transfertransistoren (TT2, TT12) jeweils mit einem von zwei dritten Betriebsartenauswahl-Signalen (04,05) verbunden sind,
- daß das Gate des einen ersten Transfertransistors (TT1) mit der anderen Bitleitungshälfte (BLH) verbunden ist und daß das Gate des anderen ersten Transfertransistors (TT11) mit der einen Bitleitungshälfte (BLH) verbunden ist (FIG 5).

7. Integrierte Halbleiterschaltung nach Anspruch 6, dadurch gekennzeichnet,
- daß die Gates der beiden ersten Transfertransistoren (TT1,TT11) zusätzlich mit den ersten Elektroden zweier zwischenspeichernder Kapazitäten (C1,C11) verbunden sind unter Bildung zweier Speicherknoten (S1,S11
- daß die zweiten Elektroden der zwischenspeichernden Kapazitäten (C1,C11) mit dem festen Potential (VSS;VDD) verbunden sind,
- daß zwischen den beiden Speicherknoten (S1,S11) und den entsprechenden Bitleitungshälften (BLH,BLH) Speichertransistoren (ST1,ST11) mit ihren Kanälen angeordnet sind und
- daß die Gates der Speichertransistoren (ST1,ST11) mit einem vierten Betriebsartenauswahl-Signal (06) verbunden sind (FIG 6).

8. Integrierte Halbleiterschaltung nach Anspruch 6, dadurch gekennzeichnet,
- daß die Gates der beiden ersten Transfertransistoren (TT1, TT11) zusätzlich mit den ersten Elektroden zweier zwischenspeichernder Kapazitäten (C1,C11) verbunden sind unter Bildung zweier Speicherknoten (S1,S11
- daß die zweiten Elektroden der zwischenspeichernden Kapazitäten (C1,C11) mit dem festen Potential (VSS;VDD) verbunden sind,
- daß zwischen den beiden Speicherknoten (S1,S11) und den entsprechenden Bitleitungshälften (BLH,BLH) Speichertransistoren (ST1,ST11) mit ihren Kanälen angeordnet sind und
- daß jedes Gate der Speichertransistoren (ST1,ST11) mit einem von zwei vierten Betriebsartenauswahl-Signalen (06,07) verbunden ist (FIG 7).

9. Integrierte Halbleiterschaltung nach Anspruch 7 oder 8, dadurch gekennzeichnet,
- daß bei jeder logischen Einheit (LU) der erste Anschluß des Ladekondensators (C) weiterhin über den Kanal eines Schiebetransistors (TS) mit einer der Bitleitungshälften (BLH,BLH) der in Reihenfolge vorhergehenden oder nachfolgenden Bitleitung (BL) verbunden ist und
- daß am Gate des Schiebetransistors (TS) ein Schiebesignal (0S) als fünftes Betriebsartenauswahl-Signal anliegt (FIG 8,9).

10. Integrierte Halbleiterschaltung nach Anspruch 9, dadurch gekennzeichnet, daß bei der in der Reihenfolge ersten logischen Einheit (LU) der erste Anschluß des Ladekondensators (C) über den Schiebetransistor (TS) mit der in der Reihenfolge letzten Bitleitung (BL) verbunden ist.

11. Integrierte Halbleiterschaltung nach Anspruch 9, dadurch gekennzeichnet, daß bei der in der Reihenfolge letzten logischen Einheit (LU) der erste Anschluß des Ladekondensators (C) über den Schiebetransistor (TS) mit der in der Reihenfolge ersten Bitleitung (BL) verbunden ist.

12. Integrierte Halbleiterschaltung nach einem der Ansprüche 7 bis 11, dadurch gekennzeichnet, daß die zwischenspeichernden Kapazitäten (C1,C11) als parasitäre Kapazitäten der ersten Transfertransistoren (TT1,TT11) realisiert sind.

13. Integrierte Halbleiterschaltung nach einem der vorhergehenden Ansprüche, dadurch gekennzeichnet, daß der Ladekondensator (C) jeder logischen Einheit (LU) durch eine statische Speicherzelle ersetzt ist.

14. Integrierte Halbleiterschaltung nach einem der Ansprüche 1 bis 13, dadurch gekennzeichnet, daß die Speicherzellen (MC) dynamische Random-Access-Speicherzellen sind.

15. Integrierte Halbleiterschaltung nach einem der Ansprüche 1 bis 13, dadurch gekennzeichnet, daß die Speicherzellen (MC) statische Random-Access-Speicherzellen sind.

16. Integrierte Halbleiterschaltung nach einem der Ansprüche 1 bis 13, dadurch gekennzeichnet, daß die Speicherzellen (MC) Speicherzellen vom nicht-flüchtigen Typ sind.

## Patentansprüche (Patentansprüche für folgende(n) Vertragsstaat(en) : :, FR, GB)

1. Integrierte Halbleiterschaltung mit einem Speicherbereich (MEM),
- der wenigstens ein Speicherzellenfeld (MCF) mit über Wortleitungen (WL) und Bitleitungen (BL) adressierbaren Speicherzellen (MC) enthält,
- der eine der Anzahl der Bitleitungen (BL) entsprechende Anzahl von Bewerterschaltungen (AMPL) enthält, wobei jede Bewerterschaltung (AMPL) so mit einer Bitleitung (BL) verbunden ist, daß sie diese in zwei wenigstens annähernd gleiche Bitleitungshälften (BLH,BLH) aufteilt,
- der einen Block von logischen Einheiten (LU) enthält,
- bei dem jede logische Einheit (LU) mit einer Bitleitung (BL) über deren beide Bitleitungshälften (BLH,BLH) verbunden ist,,
- wobei die logischen Einheiten (LU) einer digitalen Verarbeitung von aus dem Speicherbereich (MEM) über die Bitleitungen (BL) ausgelesenen, bewerteten Daten dienen,
- bei dem der Block von logischen Einheiten (LU) in verschiedenen Betriebsarten (MODk, k = 1...n) betreibbar ist, die durch Betriebsartenauswahlsignale (0j, j = 1...m) wählbar sind,
- wobei in einer ersten Betriebsart (MOD1) alle Betriebsartenauswahlsignale (0j) deaktiviert sind, so daß die ausgelesenen, bewerteten Daten unverändert bleiben,
dadurch gekennzeichnet,
- daß jede logische Einheit (LU) wenigstens zwei einer Dateninversion der ausgelesenen, bewerteten Daten dienende Transistoren (T1,T2) und einen Ladekondensator (C) enthält,
- daß die Drains der der Dateninversion dienenden Transistoren (T1,T2) mit einem ersten Anschluß des Ladekondensators (C) verbunden sind, dessen zweiter Anschluß an ein festes Potential (VSS;VDD) angeschlossen ist,
- daß jede Source der Transistoren (T1,T2) mit einer der beiden Bitleitungshälften (BLH;BLH) verbunden ist,
- daß die Gates der Transistoren (T1,T2) mit zwei ersten Betriebsartenauswahl-Signalen (01,02) verbunden sind und
- daß die Dateninversion eine zweite Betriebsart (MOD2) ist (FIG 3).

2. Integrierte Halbleiterschaltung nach Anspruch 1, dadurch gekennzeichnet,
- daß die ersten Anschlüsse der Ladekondensatoren (C) über dritte Transistoren (T3) schaltbar mit einer gemeinsamen Leitung (L) verbunden sind, die auf eines der festen Potentiale (VDD;VSS) vorladbar ist,
- daß die gemeinsame Leitung (L) mit einer Diskriminatorschaltung (DISC) verbunden ist zur Erkennung des Ladezustandes der gemeinsamen Leitung (L),
- daß die dritten Transistoren (T3) durch ein zweites Betriebsartenauswahl-Signal (03) gesteuert sind zur Durchführung eines i-fachen logischen Vergleichs der ausgelesenen, bewerteten Daten mit i = Anzahl der logischen Einheiten (LU),
- daß der i-fache logische Vergleich eine dritte Betriebsart (MOD3) ist und
- daß das Ergebnis des i-fachen logischen Vergleiches am Ausgang der Diskriminatorschaltung (DISC) anliegt (FIG 4).

3. Integrierte Halbleiterschaltung nach Anspruch 2, dadurch gekennzeichnet, daß die gemeinsame Leitung (L) mit einer Stützkapazität (CL) verbunden ist, die ihrerseits wiederum mit einem der festen Potentiale (VDD;VSS) verbunden ist.

4. Integrierte Halbleiterschaltung nach Anspruch 1, 2 oder 3 , dadurch gekennzeichnet,
- daß zwischen den Drains der ersten beiden Transistoren (T1,T2) und den beiden Bitleitungshälften (BLH,BLH) je ein erster Transfertransistor (TT1,TT11) und ein zweiter Transfertransistor (TT2,TT12) mit ihren Kanälen in Serie hintereinander angeordnet sind,
- daß die Gates der beiden zweiten Transfertransistoren (TT2, TT12) jeweils mit einem von zwei dritten BetriebsartenauswahlSignalen (04,05) verbunden sind,
- daß das Gate des einen ersten Transfertransistors (TT1) mit der anderen Bitleitungshälfte (BLH) verbunden ist und daß das Gate des anderen ersten Transfertransistors (TT11) mit der einen Bitleitungshälfte (BLH) verbunden ist (FIG 5).

5. Integrierte Halbleiterschaltung nach Anspruch 4, dadurch gekennzeichnet,
- daß die Gates der beiden ersten Transfertransistoren (TT1,TT11) zusätzlich mit den ersten Elektroden zweier zwischenspeichernder Kapazitäten (C1,C11) verbunden sind unter Bildung zweier Speicherknoten (S1,S11
- daß die zweiten Elektroden der zwischenspeichernden Kapazitäten (C1,C11) mit dem festen Potential (VSS;VDD) verbunden sind,
- daß zwischen den beiden Speicherknoten (S1,S11) und den entsprechenden Bitleitungshälften (BLH,BLH) Speichertransistoren (ST1,ST11) mit ihren Kanälen angeordnet sind und
- daß die Gates der Speichertransistoren (ST1,ST11) mit einem vierten Betriebsartenauswahl-Signal (06) verbunden sind (FIG 6).

6. Integrierte Halbleiterschaltung nach Anspruch 4, dadurch gekennzeichnet,
- daß die Gates der beiden ersten Transfertransistoren (TT1, TT11) zusätzlich mit den ersten Elektroden zweier zwischenspeichernder Kapazitäten (C1,C11) verbunden sind unter Bildung zweier Speicherknoten (S1,S11
- daß die zweiten Elektroden der zwischenspeichernden Kapazitäten (C1,C11) mit dem festen Potential (VSS;VDD) verbunden sind,
- daß zwischen den beiden Speicherknoten (S1,S11) und den entsprechenden Bitleitungshälften (BLH,BLH) Speichertransistoren (ST1,ST11) mit ihren Kanälen angeordnet sind und
- daß jedes Gate der Speichertransistoren (ST1,ST11) mit einem von zwei vierten Betriebsartenauswahl-Signalen (06,07) verbunden ist (FIG 7).

7. Integrierte Halbleiterschaltung nach Anspruch 5 oder 6, dadurch gekennzeichnet,
- daß bei jeder logischen Einheit (LU) der erste Anschluß des Ladekondensators (C) weiterhin über den Kanal eines Schiebetransistors (TS) mit einer der Bitleitungshälften (BLH,BLH) der in Reihenfolge vorhergehenden oder nachfolgenden Bitleitung (BL) verbunden ist und
- daß am Gate des Schiebetransistors (TS) ein Schiebesignal (0S) als fünftes Betriebsartenauswahl-Signal anliegt (FIG 8,9).

8. Integrierte Halbleiterschaltung nach Anspruch 7, dadurch gekennzeichnet, daß bei der in der Reihenfolge ersten logischen Einheit (LU) der erste Anschluß des Ladekondensators (C) über den Schiebetransistor (TS) mit der in der Reihenfolge letzten Bitleitung (BL) verbunden ist.

9. Integrierte Halbleiterschaltung nach Anspruch 7, dadurch gekennzeichnet, daß bei der in der Reihenfolge letzten logischen Einheit (LU) der erste Anschluß des Ladekondensators (C) über den Schiebetransistor (TS) mit der in der Reihenfolge ersten Bitleitung (BL) verbunden ist.

10. Integrierte Halbleiterschaltung nach einem der Ansprüche 5 bis 9, dadurch gekennzeichnet, daß die zwischenspeichernden Kapazitäten (C1,C11) als parasitäre Kapazitäten der ersten Transfertransistoren (TT1, TT11) realisiert sind.

11. Integrierte Halbleiterschaltung nach einem der vorhergehenden Ansprüche, dadurch gekennzeichnet, daß der Ladekondensator (C) jeder logischen Einheit (LU) durch eine statische Speicherzelle ersetzt ist.

12. Integrierte Halbleiterschaltung nach einem der Ansprüche 1 bis 11, dadurch gekennzeichnet, daß die Speicherzellen (MC) dynamische Random-Access-Speicherzellen sind.

13. Integrierte Halbleiterschaltung nach einem der Ansprüche 1 bis 11, dadurch gekennzeichnet, daß die Speicherzellen (MC) statische Random-Access-Speicherzellen sind.

14. Integrierte Halbleiterschaltung nach einem der Ansprüche 1 bis 11, dadurch gekennzeichnet, daß die Speicherzellen (MC) Speicherzellen vom nichtflüchtigen Typ sind.

## Claims (Claims for the following Contracting State(s) : AT, IT, NL)

1. Integrated semiconductor circuit having a memory region (MEM),
- which includes at least one memory cell field (MCF) with memory cells (MC) which can be addressed via wordlines (WL) and bitlines (BL), and
- which includes a number of evaluator circuits (AMPL) corresponding to the number of bitlines (BL), in which each evaluator circuit (AMPL) is connected to a bitline (BL) so that it divides the latter into two at least approximately identical bitline halves (BLH, BLH), characterized by the following features:
- the semiconductor circuit includes furthermore a block of logic units (LU),
- each logic unit (LU) is connected to a bitline (BL) via its two bitline halves (BLH, BLH),
- the logic units (LU) serve for a digital processing of evaluated data read out from the memory region (MEM) via the bitlines (BL),
- the block of logic units (LU) can be operated in differing operating modes (MODk, k = 1...n),
- the operating modes (MODk) are selectable by operating mode selection signals (0j, j = 1...m).

2. Integrated semiconductor circuit to Claim 1, characterized in that in a first operating mode (MOD1) all operating mode selection signals (0j) are deactivated, so that the read-out evaluated data remain unchanged.

3. Integrated semiconductor circuit according to Claim 1 or 2, characterized in that
- each logic unit (LU) includes at least two transistors (T1, T2) serving for a data inversion of the read-out, evaluated data, and a charge capacitor (C),
- the drains of the transistors (T1, T2) serving for the data inversion are connected to a first connection of the charge capacitor (C), the second connection of which is connected to a fixed potential (VSS;VDD),
- each source of the transistors (T1, T2) is connected to one of the two bitline halves (BLH;BLH),
- the gates of the transistors (T1, T2) are connected to two first operating mode selection signals (01, 02), and
- the data inversion is a second operating mode (MOD2) (FIG. 3).

4. Integrated semiconductor circuit according to Claim 3, characterized in that
- the first connections of the charge capacitors (C) are connected via third transistors (T3) switchably to a common line (L), which is prechargeable to one of the fixed potentials (VDD;VSS),
- the common line (L) is connected to a discriminator circuit (DISC) for the recognition of the charge state of the common line (L),
- the third transistors (T3) are controlled by a second operating mode selection signal (03) for the performance of an i-fold logic comparison of the read-out, evaluated data where i = number of the logic units (LU),
- the i-fold logic comparison is a third operating mode (MOD3), and
- the result of the i-fold logic comparison is present at the output of the discriminator circuit (DISC) (FIG. 4).

5. Integrated semiconductor circuit according to Claim 4, characterized in that the common line (L) is connected to a support capacitor (CL), which on its part is in turn connected to one of the fixed potentials (VDD;VSS).

6. Integrated semiconductor circuit according to Claim 3, 4 or 5, characterized in that
- in each instance one first transfer transistor (TT1, TT11) and one second transfer transistor (TT2, TT12) are series-connected with their channels disposed in series between the drains of the first two transistors (T1, T2) and the two bitline halves (BLH, BLH),
- the gates of the two second transfer transistors (TT2, TT12) are connected in each instance to one of two third operating mode selection signals (04, 05),
- the gate of the one first transfer transistor (TT1) is connected to the other bitline half (BLH), and the gate of the other first transfer transistor (TT11) is connected to the one bitline half (BLH) (FIG. 5).

7. Integrated semiconductor circuit according to Claim 6, characterized in that
- the gates of the two first transfer transistors (TT1, TT11) are additionally connected to the first electrodes of two buffer store capacitors (C1, C11) with the formation of two memory nodes (S1, S11
- the second electrodes of the buffer store capacitors (C1, C11) are connected to the fixed potential (VSS;VDD),
- memory transistors (ST1, ST11) are disposed with their channels between the two memory nodes (S1, S11) and the corresponding bitline halves (BLH, BLH), and
- the gates of the memory transistors (ST1, ST11) are connected to a fourth operating mode selection signal (06) (FIG. 6).

8. Integrated semiconductor circuit according to Claim 6, characterized in that
- the gates of the two first transfer transistors (TT1, TT11) are additionally connected to the first electrodes of two buffer store capacitors (C1, C11) with the formation of two memory nodes (S1, S11
- the second electrodes of the buffer store capacitors (C1, C11) are connected to the fixed potential (VSS;VDD),
- memory transistors (ST1, ST11) are disposed with their channels between the two memory nodes (S1, S11) and the corresponding bitline halves (BLH, BLH), and
- each gate of the memory transistors (ST1, ST11) is connected to one of two fourth operating mode selection signals (06, 07) (FIG. 7).

9. Integrated semiconductor circuit according to Claim 7 or 8, characterized in that
- in the case of each logic unit (LU) the first connection of the charge capacitor (C) is furthermore connected via the channel of a shift transistor (TS) to one of the bitline halves (BLH, BLH) of the bitline (BL) which precedes or follows in sequence, and
- a shift signal (0S) is present as the fifth operating mode selection signal at the gate of the shift transistor (TS) (FIGS. 8, 9).

10. Integrated semiconductor circuit according to Claim 9, characterized in that, in the case of the logic unit (LU) which is the first in the sequence, the first connection of the charge capacitor (C) is connected via the shift transistor (TS) to the bitline (BL) which is the last in the sequence.

11. Integrated semiconductor circuit according to Claim 9, characterized in that, in the case of the logic unit (LU) which is the last in the sequence, the first connection of the charge capacitor (C) is connected via the shift transistor (TS) to the bitline (BL) which is the first in the sequence.

12. Integrated semiconductor circuit according to one of Claims 7 to 11, characterized in that the buffer store capacitors (C1, C11) are realized as stray capacitances of the first transfer transistors (TT1, TT11).

13. Integrated semiconductor circuit according to one of the preceding claims, characterized in that the charge capacitor (C) of each logic unit (LU) is replaced by a static memory cell.

14. Integrated semiconductor circuit according to one of Claims 1 to 13, characterized in that the memory cells (MC) are dynamic random access memory cells.

15. Integrated semiconductor circuit according to one of Claims 1 to 13, characterized in that the memory cells (MC) are static random access memory cells.

16. Integrated semiconductor circuit according to one of Claims 1 to 13, characterized in that the memory cells (MC) are memory cells of the non-volatile type.

## Claims (Claims for the following Contracting State(s) : DE, FR, GB)

1. Integrated semiconductor circuit having a memory region (MEM),
- which includes at least one memory cell field (MCF) with memory cells (MC) which can be addressed via wordlines (WL) and bitlines (BL),
- which includes a number of evaluator circuits (AMPL) corresponding to the number of bitlines (BL), in which each evaluator circuit (AMPL) is connected to a bitline (BL) so that it divides the latter into two at least approximately identical bitline halves (BLH, BLH),
- which includes a block of logic units (LU),
- in which each logic unit (LU) is connected to a bitline (BL) via its two bitline halves (BLH, BLH),
- in which the logic units (LU) serve for a digital processing of evaluated data read out from the memory region (MEM) via the bitlines (BL),
- in which the block of logic units (LU) can be operated in differing operating modes (MODk, k = 1...n), which are selectable by operating mode selection signals (0j, j = 1...m),
- in which in a first operating mode (MOD1) all operating mode selection signals (0j) are deactivated, so that the read-out evaluated data remain unchanged, characterized in that
- each logic unit (LU) includes at least two transistors (T1, T2) serving for a data inversion of the read-out, evaluated data, and a charge capacitor (C),
- the drains of the transistors (T1, T2) serving for the data inversion are connected to a first connection of the charge capacitor (C), the second connection of which is connected to a fixed potential (VSS;VDD),
- each source of the transistors (T1, T2) is connected to one of the two bitline halves (BLH;BLH),
- the gates of the transistors (T1, T2) are connected to two first operating mode selection signals (01, 02), and
- the data inversion is a second operating mode (MOD2) (FIG. 3).

2. Integrated semiconductor circuit according to Claim 1, characterized in that
- the first connections of the charge capacitors (C) are connected via third transistors (T3) switchably to a common line (L), which is prechargeable to one of the fixed potentials (VDD;VSS),
- the common line (L) is connected to a discriminator circuit (DISC) for the recognition of the charge state of the common line (L),
- the third transistors (T3) are controlled by a second operating mode selection signal (03) for the performance of an i-fold logic comparison of the read-out, evaluated data where i = number of the logic units (LU),
- the i-fold logic comparison is a third operating mode (MOD3), and
- the result of the i-fold logic comparison is present at the output of the discriminator circuit (DISC) (FIG. 4).

3. Integrated semiconductor circuit according to Claim 2, characterized in that the common line (L) is connected to a support capacitor (CL), which on its part is in turn connected to one of the fixed potentials (VDD;VSS).

4. Integrated semiconductor circuit according to Claim 1, 2 or 3, characterized in that
- in each instance one first transfer transistor (TT1, TT11) and one second transfer transistor (TT2, TT12) are series-connected with their channels disposed in series between the drains of the first two transistors (T1, T2) and the two bitline halves (BLH, BLH),
- the gates of the two second transfer transistors (TT2, TT12) are connected in each instance to one of two third operating mode selection signals (04, 05),
- the gate of the one first transfer transistor (TT1) is connected to the other bitline half (BLH), and the gate of the other first transfer transistor (TT11) is connected to the one bitline half (BLH) (FIG. 5).

5. Integrated semiconductor circuit according to Claim 4, characterized in that
- the gates of the two first transfer transistors (TT1, TT11) are additionally connected to the first electrodes of two buffer store capacitors (C1, C11) with the formation of two memory nodes (S1, S11 ),
- the second electrodes of the buffer store capacitors (C1, C11) are connected to the fixed potential (VSS;VDD),
- memory transistors (ST1, ST11) are disposed with their channels between the two memory nodes (S1, S11) and the corresponding bitline halves (BLH, BLH), and
- the gates of the memory transistors (ST1, ST11) are connected to a fourth operating mode selection signal (06) (FIG. 6).

6. Integrated semiconductor circuit according to Claim 4, characterized in that
- the gates of the two first transfer transistors (TT1, TT11) are additionally connected to the first electrodes of two buffer store capacitors (C1, C11) with the formation of two memory nodes (S1, S11 ),
- the second electrodes of the buffer store capacitors (C1, C11) are connected to the fixed potential (VSS;VDD),
- memory transistors (ST1, ST11) are disposed with their channels between the two memory nodes (S1, S11) and the corresponding bitline halves (BLH, BLH), and
- each gate of the memory transistors (ST1, ST11) is connected to one of two fourth operating mode selection signals (06, 07) (FIG. 7).

7. Integrated semiconductor circuit according to Claim 5 or 6, characterized in that
- in the case of each logic unit (LU) the first connection of the charge capacitor (C) is furthermore connected via the channel of a shift transistor (TS) to one of the bitline halves (BLH, BLH) of the bitline (BL) which precedes or follows in sequence, and
- a shift signal (0S) is present as the fifth operating mode selection signal at the gate of the shift transistor (TS) (FIGS. 8, 9).

8. Integrated semiconductor circuit according to Claim 7, characterized in that, in the case of the logic unit (LU) which is the first in the sequence, the first connection of the charge capacitor (C) is connected via the shift transistor (TS) to the bitline (BL) which is the last in the sequence.

9. Integrated semiconductor circuit according to Claim 7, characterized in that, in the case of the logic unit (LU) which is the last in the sequence, the first connection of the charge capacitor (C) is connected via the shift transistor (TS) to the bitline (BL) which is the first in the sequence.

10. Integrated semiconductor circuit according to one of Claims 5 to 9, characterized in that the buffer store capacitors (C1, C11) are realized as stray capacitances of the first transfer transistors (TT1, TT11).

11. Integrated semiconductor circuit according to one of the preceding claims, characterized in that the charge capacitor (C) of each logic unit (LU) is replaced by a static memory cell.

12. Integrated semiconductor circuit according to one of Claims 1 to 11, characterized in that the memory cells (MC) are dynamic random access memory cells.

13. Integrated semiconductor circuit according to one of Claims 1 to 11, characterized in that the memory cells (MC) are static random access memory cells.

14. Integrated semiconductor circuit according to one of Claims 1 to 11, characterized in that the memory cells (MC) are memory cells of the non-volatile type.

## Revendications (Revendications pour l'(les) Etat(s) contractant(s) suivant(s) : suivants : AT, IT, NL)

1. Circuit intégré à semiconducteurs comportant une zone de mémoire (MEM)
- qui comporte au moins une zone de cellules de mémoire (MCF) comportant des cellules de mémoire (MC) pouvant être adressées par l'intermédiaire de lignes de transmission de mots (WL) et de lignes de transmission de bits (LB), et
- qui comporte un nombre de circuits d'évaluation (AMPL), qui correspond au nombre des lignes de transmission de bits (BL), chaque circuit d'évaluation (AMPL) étant connecté à une ligne de transmission de bits (BL) de telle sorte qu'il divise cette dernière en deux moitiés au moins approximativement identiques (BLH,BLH),
caractérisé par les particularités suivantes :
- le circuit à semiconducteurs comporte, en outre, un bloc d'unités logiques (LU),
- chaque unité logique (LU) est reliée à une ligne de transmission de bits (BL), par l'intermédiaire de ses deux moitiés (BLH, BLH),
- les unités logiques (LU) servent à réaliser un traitement numérique de données évaluées lues à partir de la zone de mémoire (MEM), par l'intermédiaire des lignes de transmission de bits (BL),
- le bloc d'unités logiques (LU) peut fonctionner selon différentes types de fonctionnement (MODk, k = 1... n),
- les types de fonctionnement (MODk) peuvent être sélectionnés par des signaux de sélection de type de fonctionnement (0j, j = 1... m).

2. Circuit intégré à semiconducteurs suivant la revendication 1, caractérisé par le fait que dans un premier type de fonctionnement (MOD1), tous les signaux de sélection de type de fonctionnement (0j) sont désactivés, de sorte que les données évaluées lues restent inchangées.

3. Circuit intégré à semiconducteurs suivant la revendication 1 ou 2, caractérisé par le fait
- que chaque unité logique (LU) comporte au moins deux transistors (T1,T2), qui sont utilisés pour inverser les données lues et évaluées, et un condensateur de charge (C),
- que les drains des transistors (T1,T2) utilisés pour l'inversion des données sont raccordés à une première borne du condensateur de charge (C), dont la seconde borne est raccordée à un potentiel fixe (VSS.VDD),
- que chaque source des transistors (T1,T2) est raccordée à l'une des deux moitiés (BLH;BLH) de la ligne de transmission de bits,
- que les grilles des transistors (T1,T2) reçoivent les deux premiers signaux de sélection de type de fonctionnement (01,02), et
- que l'inversion des données est un second type de fonctionnement (MOD2) (figure 3).

4. Circuit intégré à semiconducteurs suivant la revendication 3, caractérisé par le fait
- que les premières bornes des condensateurs de charge (C) sont raccordées, par l'intermédiaire de troisièmes transistors (T3), et d'une manière commutable, à une ligne commune (L), qui peut être préchargée à l'un des potentiels fixes (VDD;VSS),
- que la ligne commune (L) est raccordée à un circuit discriminateur (DISC) pour identifier l'état de charge de la ligne commune (T),
- que les troisièmes transistors (T3) sont commandés par un second signal de sélection du type de fonctionnement (03), pour l'exécution d'une i-ème comparaison logique des données lues et évaluées, avec i = nombre des unités logiques (LU),
- que la i-ème comparaison logique est un troisième type de fonctionnement (MOD3), et
- que le résultat de la i-ème comparaison logique est délivré à la sortie du circuit discriminateur (DISC) (figure 4).

5. Circuit intégré à semiconducteurs suivant la revendication 4, caractérisé par le fait que la ligne commune (L) est raccordée à une capacité d'assistance (CL), qui est à nouveau placée, pour sa part, à l'un des potentiels fixes, (VDD;VSS).

6. Circuit intégré à semiconducteurs suivant la revendication 3, 4 ou 5, caractérisé par le fait
- que respectivement un premier transistor de transfert (TT1,TT11) et un second transistor de transfert (TT2,TT12) sont branchés en série l'un derrière l'autre, au moyen de leurs canaux, entre les drains des deux premiers transistors (T1,T2), et les deux moitiés (BLH,BLH) de la ligne de transmission de bits,
- que les grilles des deux seconds transistors de transfert (TT2,TT12) reçoivent respectivement l'un de deux troisièmes signaux de sélection de type de fonctionnement (04,05),
- que la grille d'un premier transistor de transfert (TT1) est raccordée à l'autre moitié (BLH) de la ligne de transmission de bits, et que la grille de l'autre premier transistor de transfert (TT11) est raccordée à une moitié (BLH) de la ligne de transmission de bits (figure 5).

7. Circuit intégré à semiconducteurs suivant la revendication 6, caractérisé par le fait
- que les grilles des deux premiers transistors de transfert (TT1,TT11) sont raccordées, en outre, aux premières électrodes de deux capacités (C1,C11) qui réalisent une mémorisation temporaire, moyennant la formation de deux noeuds de mémorisation (S1,S11),
- que les secondes électrodes des capacités (C1,C11) qui réalisent une mémorisation temporaire, sont placées au potentiel fixe (VSS;VDD),
- que les transistors de mémorisation (ST1,ST11) sont disposés, par leurs canaux, entre les deux noeuds de mémorisation (S1,S11) et les moitiés correspondantes (BLH,BLH) des lignes de transmission de bits,
- que les grilles des transistors de mémorisation (ST1,ST11) reçoivent un quatrième signal de sélection de type de fonctionnement (06) (figure 6).

8. Circuit intégré à semiconducteurs suivant la revendication 6, caractérisé par le fait
- que les grilles des deux premiers transistors de transfert (TT1,TT11) sont raccordées, en outre, aux premières électrodes de deux capacités (C1,C11) qui réalisent une mémorisation temporaire, moyennant la formation de deux noeuds de mémoire (S1,S11),
- que les secondes électrodes des capacités (C1,C11) qui réalisent une mémorisation temporaire, sont placées au potentiel fixe (VSS;VDD),
- que des transistors de mémorisation (ST1,ST11) sont disposés, par leurs canaux, entre les deux noeuds de mémoire (S1,S11) et les moitiés correspondantes (BLH,BLH) de la ligne de transmission de bits, et
- que chaque grille des transistors de mémorisation (ST1,ST11) reçoit l'un de deux quatrièmes signaux de sélection de type de fonctionnement (06,07) (figure 7).

9. Circuit intégré à semiconducteurs suivant la revendication 7 ou 8, caractérisé par le fait
- que, dans chaque unité logique (LU), la première borne du condensateur de charge (C) est raccordée, en outre, et par l'intermédiaire du canal d'un transistor de décalage (TS), à l'une des moitiés (BLH, BLH) de la ligne de transmission de bits (BL) qui est la ligne de transmission de bits précédente ou suivante dans la série, et
- qu'un signal de décalage (0S) est appliqué en tant que cinquième signal de sélection de type de fonctionnement à la grille du transistor de décalage (TS) (figures 8,9).

10. Circuit intégré à semiconducteurs suivant la revendication 9, caractérisé par le fait que dans le cas de la première unité logique (LU) de la série, la première borne du condensateur de charge (C) est raccordée, par l'intermédiaire du transistor de décalage (TS), à la dernière ligne de transmission de bits (BL) de la série.

11. Circuit intégré à semiconducteurs suivant la revendication 9, caractérisé par le fait que dans le cas de la dernière unité logique (LU) de la série, la première borne du condensateur de charge (C) est raccordée, par l'intermédiaire du premier transistor de décalage (TS), à la première ligne de transmission de bits (BL) de la série.

12. Circuit intégré à semiconducteurs suivant l'une des revendications 7 à 11, caractérisé par le fait que les capacités (C1,C11) qui réalisent une mémorisation intermédiaire sont agencées sous la forme de capacités parasites des premiers transistors de transfert (TT1,TT11

13. Circuit intégré à semiconducteurs suivant l'une des revendications précédentes, caractérisé par le fait que le condensateur de charge (C) de chaque unité logique (LU) est remplacé par une cellule de mémoire statique.

14. Circuit intégré à semiconducteurs suivant l'une des revendications 1 à 13, caractérisé par le fait que les cellules de mémoire (MC) sont des cellules de mémoire dynamiques à accès direct.

15. Circuit intégré à semiconducteurs suivant l'une des revendications 1 à 13, caractérisé par le fait que les cellules de mémoire (MC) sont des cellules de mémoire statiques à accès direct.

16. Circuit intégré à semiconducteurs suivant l'une des revendications 1 à 13, caractérisé par le fait que les cellules de mémoire (MC) sont des cellules de mémoire de type non volatil.

## Revendications (Revendications pour l'(les) Etat(s) contractant(s) suivant(s) : suivants : DE, FR, GB)

1. Circuit intégré à semiconducteurs comportant une zone de mémoire (MEM)
- qui comporte au moins une zone (MFC) de cellules de mémoire à cellules de mémoire (MC) pouvant être adressées par l'intermédiaire de lignes de transmission de mots (WL) et de lignes de transmission de bits (BL),
- qui comporte un nombre de circuits d'évaluation (AMPL), qui correspond au nombre des lignes de transmission de bits (BL), un circuit d'évaluation (AMPL) étant connecté à une ligne de transmission de bits (BL) de telle sorte qu'il subdivise cette dernière en deux moitiés au moins approximativement identiques (BLH, BLH),
- qui comporte un bloc d'unités logiques (LU),
- dans lequel chaque unité logique (LU) est raccordée à une ligne de transmission de bits (BL), par l'intermédiaire des deux moitiés (BLH, BLH) de cette ligne, et
- dans lequel les unités logiques (LU) servent à réaliser un traitement numérique de données évaluées, lues à partir de la zone de mémoire (MEM), par l'intermédiaire des lignes de transmission de bits (BL),
- dans lequel le bloc d'unités logiques (LU) peut fonctionner selon différents types de fonctionnement (MODk, k = 1...n), qui peuvent être sélectionnés au moyen de signaux de sélection de types de fonctionnement (0j, j = l...m), et
- dans lequel, dans un premier type de fonctionnement (MOD1), tous les signaux (0j) de sélection du type de fonctionnement sont désactivés de sorte que les données lues et évaluées restent inchangées,
caractérisé par le fait
- que chaque unité logique (LU) comporte au moins deux transistors (T1,T2), qui servent à inverser des données lues et évaluées, et un condensateur de charge (C),
- que les drains des transistors (T1,T2), qui servent à inverser les données, sont connectés à une première borne du condensateur de charge (C), dont la seconde borne est placée à un potentiel fixe (VSS;VDD),
- que chaque source des transistors (T1,T2) est raccordée à l'une des deux moitiés (BLH;BLH) de la ligne de transmission de bits,
- que les grilles des transistors (T1,T2) reçoivent deux premiers signaux (01,02) de sélection du type de fonctionnement, et
- que l'inversion des données est un second type de fonctionnement (MOD2) (figure 3).

2. Circuit intégré à semiconducteurs suivant la revendication 1, caractérisé par le fait
- que les premières bornes des condensateurs de charge (C) sont connectées par l'intermédiaire d'un troisième transistor (T3), d'une manière commutable, à une ligne commune (L), qui peut être préchargée à l'un des potentiels fixes (VDD;VSS),
- que la ligne commune (L) est raccordée à un circuit discriminateur (DISC) pour l'identification de l'état de charge de la ligne commune (L),
- que les troisièmes transistors (T3) sont commandés par un second signal (03) de sélection du type de fonctionnement, pour l'exécution d'une i-ème comparaison logique des données lues et évaluées, avec i = nombre des unités logiques (LU),
- que la i-ème comparaison logique est un troisième type de fonctionnement (MOD3), et
- que le résultat de la i-ème comparaison logique est délivré à la sortie du circuit discriminateur (DISC) (figure 4).

3. Circuit intégré à semiconducteurs suivant la revendication 2, caractérisé par le fait que la ligne commune (L) est connectée à une capacité d'assistance (CL) qui, pour sa part, est placée à nouveau à l'un des potentiels fixes (VDD;VSS).

4. Circuit intégré à semiconducteurs suivant la revendication 1,2 ou 3, caractérisé par le fait
- que respectivement un premier transistor de transfert (TT1,TT11) et un second transistor de transfert (TT2,TT12) sont disposés, en série l'un derrière l'autre par leurs canaux, entre les drains des deux premiers transistors (T1,T2) et les deux moitiés (BLH,BLH) de la ligne de transmission de bits,
- que les grilles des deux seconds transistors de transfert (TT2,TT12) reçoivent respectivement l'un de deux troisièmes signaux de sélection de type de fonctionnement (04,05),
- que la grille du premier transistor de transfert (TT1) est connectée à l'autre moitié (BLH) de la ligne de transmission de bits et que la grille de l'autre premier transistor de transfert (TT11) est raccordée à une moitié (BLH) de la ligne de transmission de bits (figure 5).

5. Circuit intégré à semiconducteurs selon la revendication 4, caractérisé par le fait
- que les grilles des deux premiers transistors de transfert (TT1,TT11 ) sont connectées, en outre, aux premières électrodes de deux capacités (C1,C11) réalisant une mémorisation intermédiaire, moyennant la formation de deux noeuds de mémoire (S1.S11),
- que les deux électrodes des capacités (C1,C11) réalisant une mémorisation intermédiaire, sont placées au potentiel fixe (VSS;VDD),
- que des transistors de mémorisation (ST1,ST11) sont disposés, par leurs canaux, entre les deux noeuds de mémoire (S1,S11) et les moitiés correspondantes (BLH,BLH) de la ligne de transmission de bits, et
- que les grilles des transistors de mémoire (ST1,ST11) reçoivent un quatrième signal de sélection de type de fonctionnement (06) (figure 6).

6. Circuit intégré à semiconducteurs suivant la revendication 4, caractérisé par le fait
- que les grilles des deux premiers transistors de transfert (TT1,TT11 ) sont connectées, en outre, à la première électrode de deux capacités (C1,C11) qui réalisent une mémorisation intermédiaire, moyennant la formation de deux noeuds de mémoire (S1,S11),
- que les secondes électrodes des capacités (C1,C11) qui réalisent une mémorisation intermédiaire, sont placées au potentiel fixe (VSS;VDD),
- que des transistors de mémoire (ST1,ST11) sont disposés, avec leurs canaux, entre les deux noeuds de mémoire (S1,S11) et les moitiés correspondantes (BLH,BLH) des lignes de transmission de bits, et
- que chaque grille des transistors de mémoire (ST1,ST11) reçoit l'un de deux quatrièmes signaux de sélection de type de fonctionnement (06,07) (figure 7).

7. Circuit intégré à semiconducteurs suivant la revendication 5 ou 6, caractérisé par le fait
- que dans chaque unité logique (LU1), la première borne du condensateur de charge (C) est, en outre, raccordée, par l'intermédiaire du canal d'un transistor de décalage (TS), à l'une des moitiés (BLH,BLH) de la ligne de transmission de bits (BL) qui est la ligne précédente ou suivante dans la série, et
- qu'un signal de décalage (0S) est appliqué à la gille du transistor de transfert (TS) en tant que cinquième signal de sélection de type de fonctionnement (figures 8,9).

8. Circuit intégré à semiconducteurs selon la revendication 7, caractérisé par le fait que dans la première unité logique (LU) de la série, la première borne du condensateur de charge (C) est connectée, par l'intermédiaire du transistor de décalage (TS), à la dernière ligne de transmission de bits (BL) de la série.

9. Circuit intégré à semiconducteurs suivant la revendication 7, caractérisé par le fait que dans la dernière unité logique (LU) de la série, la première borne du condensateur de charge (C) est connectée, par l'intermédiaire du transistor de transfert (TS), à la première ligne de transmission de bits (BL) de la série.

10. Circuit intégré à semiconducteurs suivant l'une des revendications 5 à 9, caractérisé par le fait que les capacités (C1,C11) qui réalisent une mémorisation intermédiaire, sont réalisées sous la forme de capacités parasites des premiers transistors de transfert (TT1,TT11

11. Circuit intégré à semiconducteurs suivant l'une des revendications précédentes, caractérisé par le fait que le condensateur de charge (C) de chaque unité logique (LU) est remplacé par une cellule de mémoire statique.

12. Circuit intégré à semiconducteurs suivant l'une des revendications 1 à 11, caractérisé par le fait que les cellules de mémoire (MC) sont des cellules de mémoire dynamiques à accès direct.

13. Circuit intégré à semiconducteurs suivant l'une des revendications 1 à 11, caractérisé par le fait que les cellules de mémoire (MC) sont des cellules de mémoire statiques à accès direct.

14. Circuit intégré à semiconducteurs suivant l'une des revendications 1 à 11, caractérisé par le fait que les cellules de mémoire (MC) sont des cellules de mémoire du type non volatil.
